# EUROPEAN PATENT SPECIFICATION

(11) **EP 3 593 150 B1**
(45) Date of publication and mention of the grant of the patent: **07.06.2023**
(21) Application number: 17711779.3
(22) Date of filing: 09.03.2017
(51) Int. Cl.: G01R 1/04

(54) **A TESTING ASSEMBLY AND METHOD FOR TESTING ELECTRICAL COMPONENTS**
TESTANORDNUNG UND VERFAHREN ZUM TESTEN VON ELEKTRISCHEN BAUELEMENTEN
ENSEMBLE DE TEST ET PROCÉDÉ DE TEST DES COMPOSANTS ÉLECTRIQUES

(43) Date of publication of application: 15.01.2020
(73) Proprietor: ISMECA Semiconductor Holding SA, 2300 La Chaux-de-Fonds (CH)
(72) Inventor: CHAVAILLAZ, David, 2000 Neuchâtel (CH); COSTE, Damien, 2400 Le Locle (CH); OBERLI, Marco, 2300 La Chaux-de-Fonds (CH); RAMEL, Guy, 1430 Orges (CH); SCHWINDENHAMMER, Patrice, 25650 Gilley (FR); VIVERGE, Philippe, 25210 Le Russey (FR)
(74) Representative: P&TS SA (AG, Ltd.)
(86) International application number: PCT/IB2017/051384
(87) International publication number: WO 2018/162956

(56) References cited:
- WO-A1-2012/143797
- WO-A1-2017/020932

## Description

### Field of the invention

The present invention concerns a testing assembly and a corresponding method for testing electrical component. In particular, the present invention concerns a testing assembly and a corresponding method, for testing the performance of transistor components under high current conditions, in which there is reduced risk of damaging the transistor components under test.

### Description of related art

In testing assemblies and methods for testing electrical components under high current conditions typically high current is supplied to the electrical component under test via a plurality of electrical contacts provided at a testing station. The electrical component under test should be positioned at the testing station such that it simultaneously electrically contacts all of the plurality of electrical contacts.

For example, the component may be a transistor component having a gate, source, and drain. Typically, a testing station for testing a transistor component will have a first group of electrical contacts which are to contact the drain of the transistor component, a second group of electrical contacts which are to contact the gate of the transistor component, and a third group of electrical contacts which are to contact the source of the transistor component. The component should be positioned at the testing station such that each of the respective first, second and third groups of electrical contacts electrically contact the respective drain, gate, and source of the transistor component.

Often in existing testing assemblies and methods for testing electrical components under high current conditions, the electrical component to be tested is not correctly positioned at the testing station. In such a case one or more of the electrical contacts in the first, second and/or third groups will fail to make electrical contact with the component; these one or more electrical contacts will thus remain exposed. When a high current is supplied to these exposed one or more electrical contacts arc discharge may occur which may result in damage to the transistor component under test.

In some existing testing assemblies and methods for testing electrical components under high current conditions, the electrical contacts as the testing station are moved to make electrical contact with the transistor device after the transistor component has been delivered to the testing station. For example, the testing station may comprise a base-plate on which the transistor component is supported; the base-plate may have the first group of electrical contacts so that when the transistor is delivered to the base-plate the first group of electrical contact will come into contact with the drain of the transistor component. The testing station may also comprise a cover-plate which has the second and third groups of electrical contacts. The cover-plate can be selectively moved towards the base-plate to bring second and third groups of electrical contacts into electrical contact with the gate and source respectively of the transistor component. Effectively when the cover-plate is moved towards the base-plate to bring second and third groups of electrical contacts into electrical contact with the gate and source respectively of the transistor component, the transistor component will be sandwiched between the first group of electrical contacts on the base-plate and the second and third groups of electrical contacts on the cover-plate. However often in existing solutions, the cover-plate is moved too close to the base-plate causing the second and third groups of electrical contacts penetrate too far into the gate and source thereby damaging the transistor component.

Additionally, over time the second and third groups of electrical contacts on the cover-plate will wear down (e.g. due to repetitive use); and this often leads to the second and third groups of electrical contact failing to penetrate far enough into the gate and source of the transistor component to establish a reliable electrical connection required for testing, when the cover-plate is moved towards the base-plate.

WO2017020932 discloses a method of handling components, the method comprising the steps of: (a) aligning a component into a predefined orientation using an alignment means; (b) placing the component onto a predefined position on a boat which is located in a loading area; (c) capturing a first image of the component after it has been placed on the boat with a first camera; (d) using the first image to identify if the component is in a predefined orientation on the boat; (e) if the component is not in said predefined orientation on the boat, then picking the component from the boat and aligning the component again using said alignment means.

WO2012143797 discloses a testing assembly for testing a singulated semiconductor die comprising a power component. The assembly comprises an current input connectable to a current source, for providing a current greater than 50 Amps to the power component; a signal output connectable to a signal analyzer, for receiving signals representing a sensed parameter of the power component sensed when the current is provided; a first contact unit, adapted to support the semiconductor die; a second contact unit, movably mounted relative to the first contact unit; and at least an electrically-conductive resilient sheath, adapted to be sandwiched between the semiconductor die and the second contact unit when the second contact unit is brought toward the semiconductor die during a test, the sheath forming part of an electrical path from the current input through at least a part of the die when thus sandwiched.

It is an aim of the present invention to obviate or mitigate at least some of the above-mentioned disadvantages of the prior art.

### Brief summary of the invention

According to the present invention there is provided method of testing a transistor component, the method comprising the steps of,
(a) capturing a first image of the transistor component which is to be positioned into a nest for testing;
(b) identifying from the first image the locations of the source and gate of the transistor component;
(c) holding the transistor component using a component handling head on a rotatable turret,
(d) using an alignment device to move the transistor component into a position on the component handling head such that the component handling head can deliver the component into a position on the nest wherein all of a plurality of electrical contacts on the base-plate of the nest will make electrical contact with the drain of the transistor component, and a portion of the plurality of electrical contacts on the cover-plate of the nest will make electrical contact with the gate of the transistor component and the remaining electrical contacts on the cover-plate of the nest will make electrical contact with the source of the transistor component, when the cover is moved to close the nest;
(e) delivering the transistor component to the nest so that all of said plurality of electrical contacts on the base-plate of the nest make electrical contact with the drain of the transistor component;
(f) moving the nest cover-plate to overlay the base-plate to close the nest and a portion of the plurality of electrical contacts on the cover-plate of the nest will make electrical contact with the gate of the transistor component and the remaining electrical contacts on the cover-plate of the nest will make electrical contact with the source of the transistor component;
(g) performing testing of the transistor component.

According to the present invention, the method further comprises the steps of,
(h) capturing a second image of the nest when the nest is closed, the image providing a side view of the cover-plate, base-plate, and transistor component; and
(i) using the second image to determine if all of said plurality of electrical contacts on the base-plate of nest overlay the drain of the transistor component, and to determine if all of the plurality of electrical contacts on the cover-plate of the nest overlay the source of the transistor component.

The method may further comprise the step of inspecting the second image to determine if there is a gap between the electrical contacts on the cover-plate of the nest and the transistor component.

The method may further comprise the step of moving the position of the base-plate towards the cover-plate if it is determined from the second image that there is a gap between the electrical contacts on the cover-plate of the nest and the transistor component, until the transistor component is moved to close the gap so that the transistor component electrically contacts the electrical contacts on the cover-plate.

A method according to claim 2 further comprising the step of inspecting the second image to determine if the distance 'R1' between the base-plate and the cover-plate on one side of the transistor component differs from the distance 'R2' between the base-plate and cover-plate on a second, opposite, side of the transistor component.

In an embodiment the second image is captured by,
passing light through windows in the cover plate;
reflecting the light which has passed through the windows to the component, cover-plate and base-plate, using reflective elements on the base plate;
receiving into camera, via other windows in cover member, light which was reflected by the component, cover-plate and base-plate.

The method may further comprise the steps of,
capturing an image of the plurality of electrical contacts provided on a base-plate of a nest, and determining from the image the position of the electrical contacts provided on a base-plate of the nest; and
capturing an image of the plurality of electrical contacts provided on the cover-plate of the nest, and determining from the image the position of the electrical contacts provided on a cover-plate of the nest;
and capturing an image of a transistor component which is due to be delivered to said nest, and determining at least locations of the source and gate of the transistor component from said image of a transistor component.

The method may further comprise the steps of,
determining from said image of the plurality of electrical contacts provided on a base-plate of a nest, said image of the plurality of electrical contacts provided on the cover-plate of the nest, and said image of a transistor component which is due to be delivered to said nest, said position on said component handling head into which the alignment device should move the component.

According to a further aspect of the present invention there is provided a testing assembly which can be used to carry out any of the above-mentioned methods, the testing assembly comprising
a turret having a plurality of component handling heads which can each carry a transistor component;
an alignment device which can move a transistor component into a predefined position on the component handling head;
a satellite table which comprises a plurality of nests, wherein each nest comprises a base-plate and a cover-plate,
a camera which is arranged to capture an image of the base plate of a nest wherein said image can be used to determine the position of electrical contacts on the base plate; a camera which is arranged to capture an image of the cover plate of the nest wherein said image can be used to determine the position of electrical contacts on the cover plate; a camera which is arranged to capture an image of the component which is due to be delivered to the nest; a camera which is arranged to capture an image of a nest when the nest is closed, the image providing a side view of the cover-plate, base-plate, and transistor component;
wherein said alignment means is configured to receive said images, and based on the images move the transistor component into a position on the component handling head such that the component handling head can deliver the component into a position on the nest wherein all of said plurality of electrical contacts on the base-plate of the nest will make electrical contact with the drain of the transistor component, and a portion of the plurality of electrical contacts on the cover-plate of the nest will make electrical contact with the gate of the transistor component and the remaining electrical contacts on the cover-plate of the nest will make electrical contact with the source of the transistor component, when the cover is moved to close the nest.

In an embodiment the base-plate comprises a raised platform which is substantially square and with projecting portions at each respective side of the square; and the cover-plate comprises a raised platform which is square and with projecting portions at each respective side of the square.

In an embodiment the base plate comprises a plurality of reflective elements which are angled relative to the plane of the base-plate; and the cover-plate comprises a corresponding plurality of apertures defined therein, such that when the cover-plate is arranged to overlay the base-plate each aperture overlays a respective reflective element.

In an embodiment the cover-plate is pivotally mounted on a follower.

In an embodiment the cover-plate may be also secured to an anchor portion, so that when follower moves upwards the cover-plate will also move upwards by a distance approximately equal to the length of spring members, at which point the spring members will restrict further vertical movement of the cover-plate, and the cover-plate will pivot on the follower at a pivot connection, thereby causing the cover-plate pivot from horizontal orientation into a vertical orientation; and such that when the follower moves downwards, the spring members will push against the cover-plate to cause the cover-plate to pivot on the follower, at a pivot connection, thereby causing the cover-plate pivot from a vertical orientation into a horizontal orientation.

The follower may comprise a first projection member which rests on and can move along an upper or lower track as the satellite table rotates.

The follower may comprise an actuator member which comprises first and second projection members which project in opposite directions; wherein the first projection member rests on and can moves an upper or lower track as the satellite table rotates, and can cooperates with a cam.

The follower may comprise a track member which has a groove defined therein which extends substantially parallel to the plane of the base-plate; and wherein the second projection member extends into the groove of the track member.

In an embodiment the testing assembly comprises a first and second cam located at different stations, wherein the first cam is rotatable to move the first projection member from the level of the lower track to the level of the upper track to cause the second projection member to push upwards against the track member; wherein the upward force which the second projection member applies to the track member will cause the follower to move upwards thereby moving the cover-plate into a vertical orientation; wherein the second cam is rotatable to move the first projection member from the level of the upper track to the level of the lower track to cause the second projection member to push downwards against the track member; wherein the downward force which the second projection member applies to the track member will cause the follower to move downward thereby moving the cover-plate into a horizontal orientation.

The or each cam may comprise a rotatable plate-member which has a one or more cut-outs defined therein; each cut-out is dimensioned such that it can receive the first projection member of a follower of a nest.

The or each cam may further comprise a sensor which is configured to detect when a first projection member has been received into the cut-out of the plate-member of a cam.

In an embodiment the plate-member is attached to a motor; wherein the motor is operable to selectively rotate the plate-member after the sensor has detected that a first projection member of a nest has been received into the cut-out of the plate-member.

In a further aspect which is not part of the present invention there is provided a component handling assembly comprising, a satellite table comprising a plurality of nests, each of which can hold a transistor component, wherein the satellite table can rotate to move the respective nests between a plurality of stations comprising
a first station where a transistor component to be tested is delivered by a component handling head on a turret onto a base-plate of a nest of a satellite table;
a second station where a cover-plate of the nest is moved to bring electrical contacts on the cover-plate into contact with the transistor component supported on the base plate;
a third station comprising a camera which is used to capture a first image which is a silhouette of the transistor component and platforms of the respective base-plate and cover-plate;
a fourth station wherein electrical tests are carried out on the transistor component;
a fifth station wherein the cover-plate is moved away from the base-plate so that the electrical contacts on the cover-plate are no longer in contact with the transistor component;
a sixth station comprising a camera which is used to capture an image of the cover plate of the nest, wherein said image is used to determine the position of the electrical contacts on the cover-plate;
   a seventh station wherein the transistor component is picked from the nest by a component handling head on a turret;
   an eight station comprising a camera which is used to capture an image of the base plate of the nest, wherein said image is used to determine the position of the electrical contacts on the base-plate.

In one embodiment which is not part of the present invention the plurality of stations further comprise a rest station where the transistor component is allowed to cool after the electrical tests have been carried out.

In one embodiment which is not part of the present invention the plurality of stations further comprise a station after the fifth station which comprises a second camera which is used to capture an image of the component; and wherein the image captured by the second camera can be inspected to determine if the transistor component has become damaged.

The component handling assembly may further comprise a camera which is arranged to capture an image of a transistor component which is to be tested, while it is held by a component handling head on the turret, before the transistor component is delivered by a component handling head on a turret onto a base-plate of a nest of a satellite table.

The component handling assembly may further comprise an alignment device which can aligns a component into a position on the component handling head, such that when the component handling head delivers the transistor component to the nest of the satellite table the transistor component will be placed at a position wherein all of the electrical contacts in the first set of electrical contacts on the base-plate of the nest make electrical contact with the drain of the transistor component; and such that when the nest is in a closed configuration, some of the electrical contacts in the second set of electrical contacts on the cover-plate of the nest make electrical contact with the gate, and, the remaining electrical contacts in the second set of electrical contacts on the cover-plate of the nest will make electrical contact with the source of the transistor component.

The alignment device may be configured to determine said position on the component handling head to which the component is to be aligned based on,
the image which is captured by the camera which is arranged to capture an image of a transistor component which is to be tested, while it is held by a component handling head on the turret;
image of the cover plate of the nest into which the component is to be placed, which was captured by the camera at the a sixth station;
and the image of the base-plate of the nest into which the component is to be placed, which was captured by the camera at the eight station.

### Brief Description of the Drawings

The present invention will be better understood with the aid of the description of an embodiment given by way of example only and illustrated by the figures, in which:
Fig. 1a shows an aerial view of a component handling assembly according to an aspect of the present invention, which comprises a testing assembly according to a further aspect of the present invention; Figs. 1b and 1c are perspective views of said component handling assembly, from different perspectives;
Fig. 2 provides a perspective view of a nest of the testing assembly;
Fig. 3a provides a perspective view of the component handling assembly from a perspective which shows a cam which can cooperate with a cam follower in a nest of Fig. 2 to configure the nest to have an open or closed configuration; at least two such cams are provided in the testing assembly, a first cam for changing the configuration of the nest from an open configuration to a closed configuration, and a second cam for changing the configuration of the nest from a closed configuration to an open configuration;
Figure 3b shows the cam and the cam follower of the cam-follower assembly shown in Fig 3a, when the nest is in an "open" configuration; figure 3c provides an illustration of the follower of Figure 3b;
Figure 3d shows the cam and the cam follower of the cam-follower assembly shown in Fig 3a, when the nest is in a "closed" configuration; figure 3e provides an illustration of the follower of Figure 3d;
Fig. 4 provides a example of a first image captured by the first camera of the testing assembly, which provides a silhouette of the base-plate23a, cover-plate 23b and transistor component 10 in the nest;
Fig. 5 provides an example of a third image of the cover plate 23b which is used to identify the position of the second set of electrical contacts on cover-plate 23b;
Fig. 6 provides an example of a fourth image of the base-plate 23a which is used to identify the position of the first set of electrical contacts on the base-plate 23a;
Fig. 7 provides an example of a fifth image captured by the fifth camera of the testing assembly used to identify the locations of the source and the gate of the transistor component.

### Detailed Description of possible embodiments of the invention

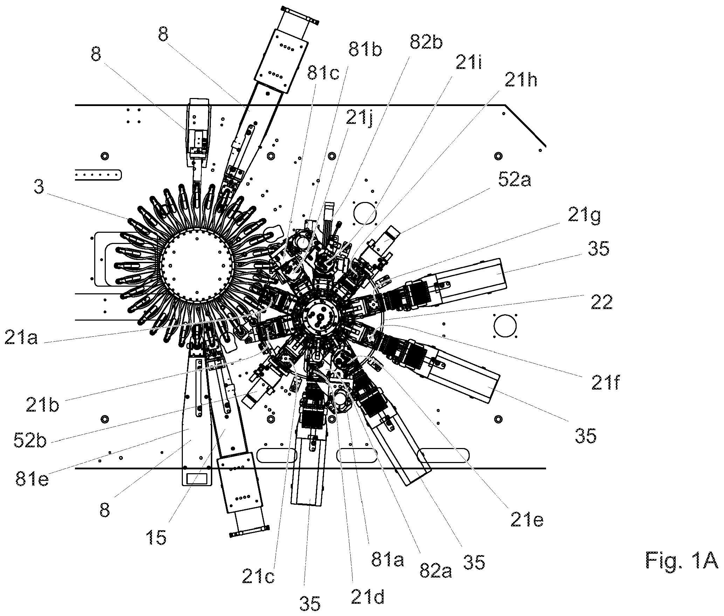

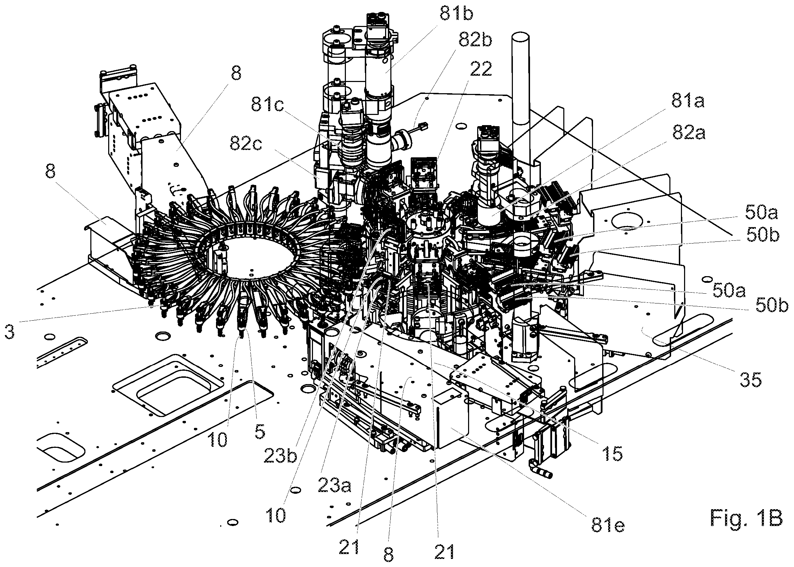

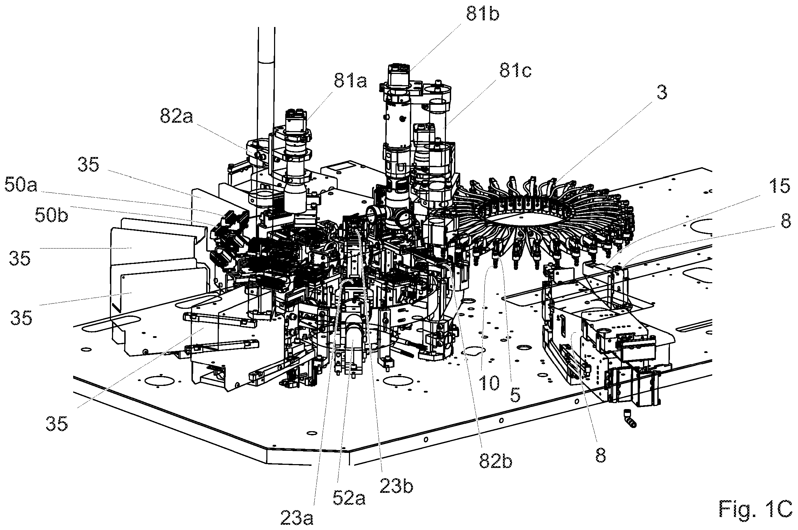

Referring to Figures 1a-c there is illustrated a component handling assembly 1 according to an embodiment of the present invention. The assembly 1 comprises a rotatable turret 3 having a plurality of component handling heads 5; each component handling head 5 can hold a respective component 10 by vacuum. In this example the components 10 are transistor components 10.

The assembly 1 comprises a plurality of stations 8 located at the periphery of the turret 3; each station 8 is configured to carry out testing (e.g. testing of the electrical or mechanical characteristics of the component) or processing of a component in some manner.

The turret 3 can be rotated iteratively to transport components between the stations 8. The component handling heads 5 can each be selectively extended from the turret 3 towards a respective station 8 to deliver the component 10 held by the handling head 5 to the station 8 beneath for processing or testing; and the component handling heads 5 can each pick the component 10 from the respective station 8 again after the processing or testing has been completed at the station 8, before the turret 3 is rotated to move the component to a position above the next station 8.

One of the stations comprises a testing assembly 20 which is suitable for testing the performance of the components under high current conditions (e.g. the performance of the component when a current of between 200-300 Amps are input to the component).

The testing assembly 20 comprises a rotatable satellite table 22 having plurality of nests 21.

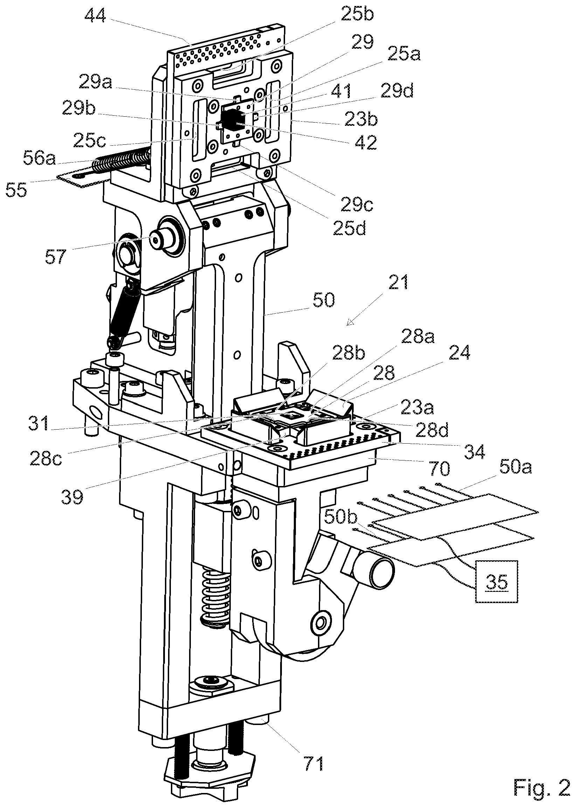

Figure 2 provides a perspective view of a nest 21. Each nest 21 comprises a base-plate 23a and a cover-plate 23b. The base-plate 23a comprises a raised platform 28 which is substantially square and with projecting portions 28a-d at each respective side of the square. The central region of the raised platform 28 comprises a plurality of holes 39, each of which can receive a respective electrical contact 31. The electrical contacts 31 are mechanically independent of one another; each electrical contact 31 can be selectively provided or removed from a respective hole 39ln this example an electrical contact 31 is provided in each hole, so as to define a first set of electrical contacts 33 which are configured to each electrically contact the drain of the transistor component 10 when the transistor component 10 is placed on the nest 21 by the component handling head 5 of the turret 3. The first set of electrical contacts 33 are electrically connected to a first PCB board 34. An lower set of electrical contacts 50b, belonging to a current source 35, can be selectively positioned of electrical contact the first PCB board 34 to supply high current to the first PCB board 34; the high current is in turn conducted to the drain of the transistor component 10 via the first set of electrical contacts 33. The base-plate 23a comprises four reflective elements 24 which are angled relative to the plane of the base-plate 23a; preferably four reflective elements 24 are arranged such that they form a 45° angle to the plane of the base-plate 23a (specifically each reflective element 24 is arranged such that the plane of the reflective element 24 forms a 45° angle with the plane of the base-plate 23a).

The cover-plate 23b comprises a raised platform 29 which is square and with projecting portions 29a-d at each respective side of the square. The central region of the raised platform 29 comprises a plurality of holes 41, each of which can receive a respective electrical contact 42. The electrical contacts 31 are mechanically independent of one another; each electrical contact 42 can be selectively provided or removed from a respective hole 29. In this example an electrical contact 42 is provided in each hole 29, so as to define a second set of electrical contacts 43 some of which are configured to electrically contact the source of the transistor component 10, and others of which are configured to electrically contact the gate of the transistor component 10, when the transistor component 10 is delivered to the nest 21 by the component handling head 5.

The second set of electrical contacts 43 are electrically connected to a second PCB board 44. An upper set of electrical contacts 50a, belonging to a current source 35, can be selectively positioned to make electrical contact with the second PCB board 44 to supply high current to the second PCB board 44, which in turn is conducted to the gate and source of the transistor component via the second set of electrical contacts 43. The cover-plate 23b comprises four apertures 25a-d defined therein. When the cover-plate 23b is arranged to overlay the base-plate 23a each aperture overlay a respective reflective element 24.

The cover-plate 23b is pivotally mounted on a follower 51. The follower 51 will move along the vertical (along a plane which is perpendicular to the plane of the base-plate 23a) by the rotation of a cam 52, as will be explained in more detail later. The cover-plate 23b is also secured to an anchor portion 55 of the testing assembly 20; in this example the cover-plate 23b is secured via two spring members 56a,b (only spring member 56a is visible in the figure) to an anchor portion 55. When the follower 51 moves upwards, the spring members 56a,b will restrict the vertical distance which the cover-plate 23b moves; specifically, when follower 51 moves upwards the cover-plate 23a will also move upwards by a distance approximately equal to the length of spring members 56a,b, at which point the spring members will restrict further vertical movement of the cover-plate 23b, and the cover-plate 23b will pivot on the follower 51 at a pivot connection 57, thereby causing the cover-plate 23b pivot from horizontal orientation into a vertical orientation (i.e. to pivot onto a plane which is perpendicular to the plane of the base-plate 23a); in this configuration the nest 21 will be considered to be in an "open" configuration. When the follower 51 moves downwards, the spring members 56a,b will push against the cover-plate 23b to cause the cover-plate 23b to pivot on the follower 51, at a pivot connection 57, thereby causing the cover-plate 23b pivot from a vertical orientation into a horizontal orientation (i.e. to pivot onto a plane which is parallel to the plane of the base-plate 23a). Continued downward movement of the follower, will move the second set of electrical contacts 43 which are on the horizontally orientated cover-plate 23b, into contact with the transistor component 10 resting on the base-plate 23a; in this configuration the nest will be considered to be in a "closed" configuration. Importantly, in this example the cover-plate 23b will already be in a horizontal orientation prior to the second set of electrical contacts 43 on the cover-plate 23b coming into contact with the transistor component 10.

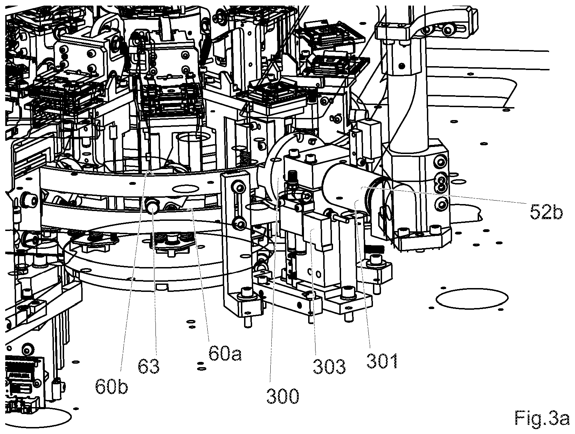

As can been seen in Figure 3a the testing assembly 20 comprise a lower and upper track 60a,b, the follower 51 of each respective nest 21 comprises a first projection member 63a which rests on and moves along a track 60a,b as the satellite table 22 is rotated. The lower track 60a is defined by a surface of a first metal band; and the upper track 60b is defined by a surface of a second metal band; the first and second metal bands run parallel to one another. A first cam 52a is located at station 8 where the nest 21 is to be adjusted to have an "open" configuration; at this station 8 the first projection member 63a is moved by a first cam 52a (which is motor driven) from the level of lower track 60b to the level upper track 60a, so as to move the follower 51 upwards, thereby moving the cover-plate 23b into a vertical orientation to put the nest 21 into its "open" configuration. A second cam 52b (not shown in Figure 3a) is located at another station 8 where the nest 21 is to be adjusted to have a "closed" configuration; at this station 8 the first projecting member 63a is moved by a second cam 52b (which is motor driven) from the level of the upper track 60a to the level of the lower track 60a, so as to move the follower 51 downwards, thereby moving the cover-plate 23b into a horizontal orientation and downwards it that horizontal orientation until the second set of electrical contacts 43 on the cover-plate 23b are in electrical contact with the transistor component 10 supported on the base-plate 23a; thereby putting the nest 21 into its "closed" configuration. Thus the testing assembly comprises at least two cams which are provided at different stations in the testing assembly: a first cam 52a for changing the configuration of the nest from a closed configuration to an open configuration, and a second cam 52b for changing the configuration of the nest from an open configuration to a closed configuration.

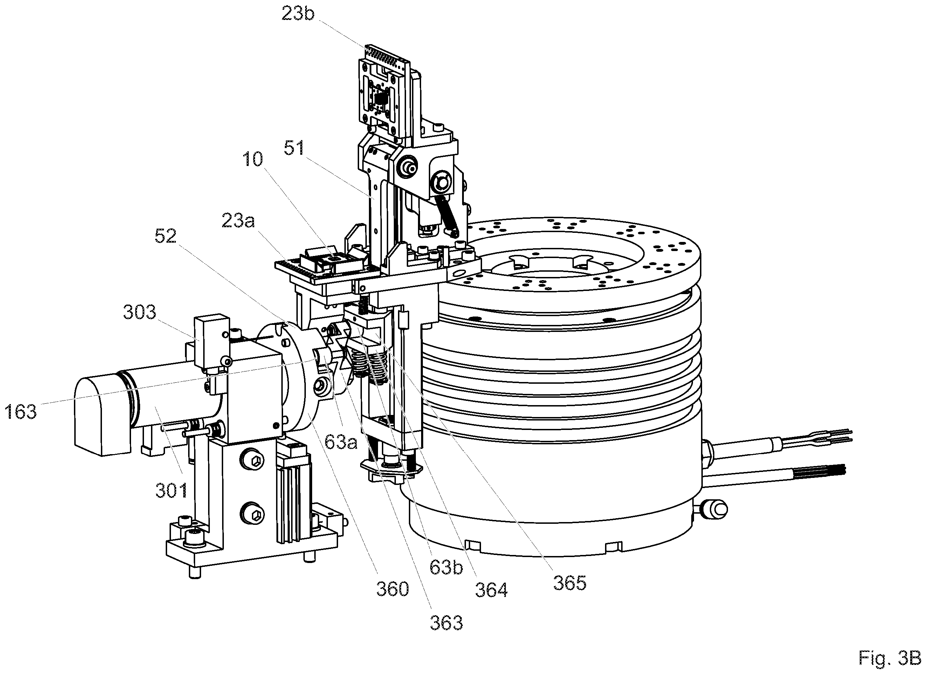

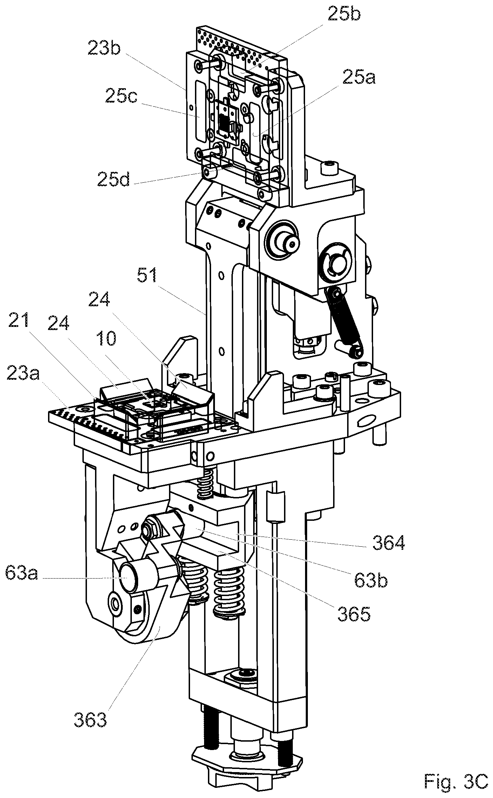

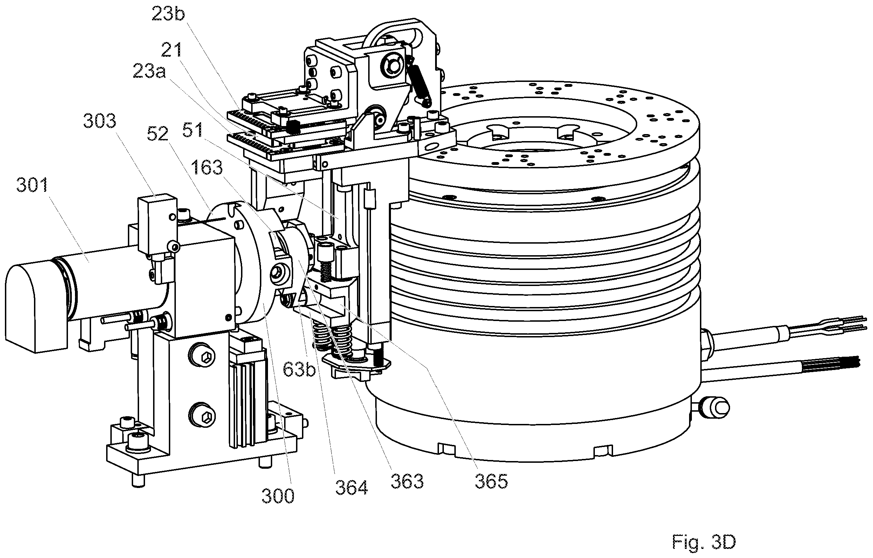

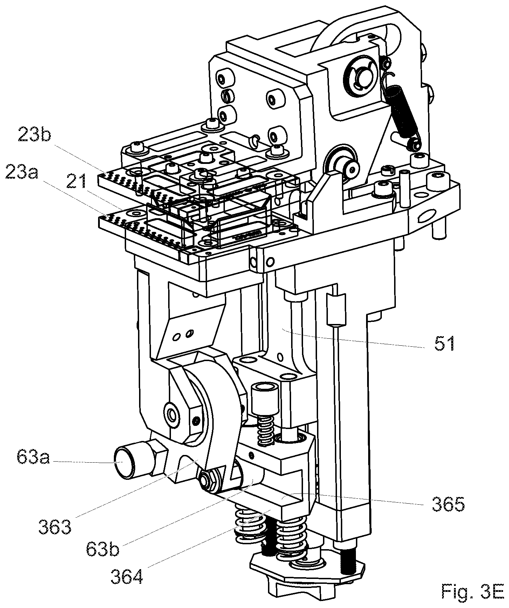

Figures 3b and 3d provide a more detailed illustration of a cam 52 (a motor drive cam) which can be used in the testing assembly 20; it will be understood that the first cam 52a and second cam 52b will each have the same configuration as the cam 52 illustrated in Figures 3b,3d. Figures 3b and 3d further shows a follower 51; it will be understood that each nest 21 in the testing assembly 20 comprises a follower 51 having the features of the follower 51 illustrated in Figures 3b and 3d. Figures 3c show the follower 51 of Figure 3b only; and figure 3e shows the follower 51 of Figure 3d only.

Referring to Figures 3b-3e, the follower 51 comprises an actuator member 363 which comprises first and second projection members 63a,63b, which project in opposite directions. The first projection member 63a rests on and moves along the track 60a,b as the satellite table 22 is rotated, and cooperates with a cam 52a,52b at stations 8 where the nest 21 is to be configured to have an "open" or "closed" configuration. The follower 51 further comprises a track member 364 which has a groove 365 defined therein which extends substantially parallel to the plane of the base-plate 23a i.e. the groove 365 extends along the horizontal. The second projection member 63b extends into the groove 365 of the track member 364.

Referring to Figures 3b and 3d, the cam 52 comprises a rotatable plate-member 300 which has a one or more cut-outs 163 defined therein; each cut-out 163 is dimensioned such that it can receive the first projection member 63a of a follower 51 of a nest 21. When the satellite table 22 is rotated to bring the nest 21 to the station 8 where the cam 52 is located, the rotation of the satellite table 22 will move the first projection member 63a of the nest 21, from the upper or lower track 60a,b, into cut-out 163 of the rotatable plate-member 300. There is further provided a sensor 303; the sensor 303 is configured to detect when a first projection member 63a has been received into the cut-out 163 of the plate-member 300 (it will be understood that the sensor 303 may take any suitable configuration, for example the sensor 303 may be an optical sensor). The plate-member 300 is attached to a motor 301; the motor 301 is operable to selectively rotate the plate-member 300 after the sensor 303 has detected that a first projection member 63a of a nest 21 has been received into the cut-out 163 of the plate-member 300.

During use, when the satellite table 22 is rotated is will move the first projection member 63a of one nest 21 from the lower track 60a into a cut-out 163 of the rotatable plate member 300 of the first cam 52a, at the station 8 where the first cam 52a is located; and will move the first projection member 63a of another nest 21 from the upper track 60b into the cut-out 163 of the rotatable plate member 300 of the second cam 52b at the station 8 where the second cam 52a is located. Addressing what the happens at the first and second cams 52a,52b respectively:

At the first cam 52a, the sensor 303 will detect that a first projection member 63a of a nest 21 has been received into a cut-out 163 of the rotatable plate member 300; in response the sensor 303 will initiate the motor 301 to rotate the plate member 300. As the plate member 300 is rotated it will move the first projection member 63a, in an arch, from the level of the lower track 60a to the level of the upper track 60b. As the plate member 300 rotates to move the first projection member 63a, in an arch, from the level of the lower track 60a to the level of the upper track 60b, this will cause the second projection member 63b to push upwards against the track member 364; the second projection member 63b will also roll horizontally along the groove of the track member 364 (in this example it will roll from right to left). The upward force which the second projection member 63b applies to the track member 364 will cause the follower 51 to move upwards thereby moving the cover-plate 23b into a vertical orientation; and thereby configuring the nest 21 to have an "open" configuration as is shown in Figure 3b. Figure 3c provides an illustration of the follower 51 when the nest 21 has been configured to have an "open" configuration. Since the plate member 300 rotates to move the first projection member 63a, in an arch, from the level of the lower track 60a to the level of the upper track 60b, the subsequent rotation of the satellite table 22 to bring the nest 21 to the next station 8 along the testing assembly 20, will move the first projection member 63a out of the cut-out 163 of the rotatable plate member 300 and onto the upper track 60b; the first projection member 63a will remain supported on, and will move along, the upper track 60b through subsequent rotations of the satellite table 22, at least until the first projection member 63a reaches the station 8 where the second cam 52b is located. As the first projection member 63a remains supported on, and moves along, the upper track 60b the cover-plate 23b is maintained in its vertical orientation i.e. the nest 21 is maintained in its open configuration.

At the second cam 52b, the sensor 303 will detect that a first projection member 63a of a nest 21 has been received into a cut-out 163 of the rotatable plate member 300; in response the sensor 303 will activate the motor 301 to rotate the plate member 300. As the plate member 300 is rotated it will move the first projection member 63a, in an arch, from the level of the upper track 60b to the level of the lower track 60a. As the plate member 300 rotates to move the first projection member 63a, in an arch, from the level of the upper track 60b to the level of the lower track 60a, this will cause the second projection member 63b to push downwards on the track member 364; the second projection member 63b will also roll horizontally along the groove of the track member 364 (in this example it will roll from left to right). The downward force which the second projection member 63b applies to the track member 364 will cause the follower 51 to move downwards thereby moving the cover-plate 23b firstly into a horizontal orientation and then move, in that horizontal orientation, towards the base-plate 23a, until the second set of electrical contacts 43 on the cover-plate 23b come into electrical contact with the transistor component 10 which is supported on the base-plate 23a; and thereby configuring the nest 21 to have an "closed" configuration, as is shown in Figure 3d. Figure 3e provides an illustration of the follower 51 when the nest 21 has been configured to have an "closed" configuration. At this stage both the first set of electrical contacts 33 on the base plate 23a and the second set of electrical contacts 43 on the cover-plate 23b will be electrical contact with the transistor component 10. Since the plate member 300 rotates to move the first projection member 63a, in an arch, from the level of the upper track 60b to the level of the lower track 60a, the subsequent rotation of the satellite table 22 to bring the nest 21 to the next station 8 along the testing assembly 20, will move the first projection member 63a out of the cut-out 163 of the rotatable plate member 300 and onto the lower track 60a; the first projection member 63a will remain supported on, and will move along, the lower track 60a through subsequent rotations of the satellite table 22, until the first projection member 63a reaches the station 8 where the first cam 52a is located. As the first projection member 63a remains supported on, and moves along, the lower track 60a the cover-plate 23b is maintained in its horizontal orientation i.e. the nest 21 is maintained in its closed configuration wherein both the first set of electrical contacts 33 on the base plate 23a and the second set of electrical contacts 43 on the cover-plate 23b are electrical contact with the transistor component 10.

Referring again to Figure 2, the base-plate 23a is secured to a platform 70; the platform 70 has a predefined fixed position so that the base-plate 23a has predefined fixed position. The position of the platform 70 can be adjusted so that the fixed predefined position of the base-plate 23a can be adjusted; for example, the platform may be raised to move the base-plate 23a towards the cover-plate 23b, or the platform may be lowered to move the base-plate 23a away from the cover-plate 23b. In this example the position of the platform 70 may be adjusted using a screw 71 the end of which abuts the platform 70; the screw 71 may be screwed clockwise to cause the screw to move in a direction towards the platform 70 thus causing the platform to raise, and may be unscrewed anticlockwise to move the screw in a direction away from the platform thus lower the platform 70.

Referring back to Figures 1a-c, the satellite table 22 rotates iteratively to consecutively bring each nest 21 to each of a plurality of different positions 21a-j (in this example there are ten different positions 21a-j; however, it will be understood that the invention is not limited to requiring ten different positions); at each position 21a-j a different step in the high current testing process is carried out:

A nest 21 located at a first position 21a defines one or the stations 8 around the periphery of the turret 3; the first position 21a defines a first station of the satellite table 22. At the first position 21a a component 10 which is to undergo testing under high current conditions, is delivered, by a respective component handling head 5, from the turret 3 to the nest 21 of the satellite table 22. Specifically, the component handling head 5 delivers the transistor component 10 onto the base plate 23a of the nest 21, so that transistor component 10 is in electrical connection with the first set of electrical contacts 33 on the base plate 23a. Specifically the transistor component 10 is delivered so that the drain of the transistor component 10 is in electrical connection with the first set of electrical contacts 33 on the base plate 23a.

Additionally, at the first position 21a transistor components 10 which have already been passed around the satellite table 22 i.e. transistor component 10 which have been brought to each of the positions 21a-j and which thus have already undergone testing under high current conditions, are picked from the nest 21 by component handling heads 5 on the turret. In this embodiment when a nest 21 arrives at the first position 21a, the transistor component 10 which is already present in the nest 21 and which has already undergone testing is first picked by an empty component handling head 5 on the turret 3; then the turret rotates one iteration to bring the next component handling head 5 (which carries a transistor component 10 which is due to be tested) to above the empty nest 21; said next component handling head 5 then delivers the transistor component 10 which it carries to the nest 21.

At a second position 21b (i.e. second station of the satellite table 22) no processing or testing step takes place. In this example the reason for this is that there is usually insufficient space to locate a testing unit or processing unit at the second position 21b due to the alignment device 15. It will be understood that the second position 21b (i.e. second station of the satellite table 22) is not essential to the invention.

At a third position 21c (i.e. third station 21c of the satellite table 22) the nest 21 is closed i.e. the cover-plate 23b is moved to bring the electrical contacts on the cover-plate 23b into contact with the transistor component 10 supported on the base plate 23a. Specifically the second cam 52b is located at the third position 21c; as the satellite table 22 is rotated to bring a nest 22 from the second to the third position 21b,21c, projecting member 63 on the nest 21 will be received into the cut-out 163 of the rotatable plate member 300 of the second cam 52b. The sensor 303 will detect that a first projection member 63a of a nest 21 has been received into a cut-out 163 of the rotatable plate member 300; in response the sensor 303 will activate the motor 301 to rotate the plate member 300. As the plate member 300 is rotated it will move the first projection member 63a, in an arch, from the level of the upper track 60b to the level of the lower track 60a. As the plate member 300 rotates to move the first projection member 63a, in an arch, from the level of the upper track 60b to the level of the lower track 60a, this will cause the second projection member 63b to push downwards on the track member 364; the second projection member 63b will also roll horizontally along the groove of the track member 364 (in this example it will roll from left to right). The downward force which the second projection member 63b applies to the track member 364 will cause the follower 51 to move downwards thereby moving the cover-plate 23b firstly into a horizontal orientation and then move, in that horizontal orientation, towards the base-plate 23a, until the second set of electrical contacts 43 on the cover-plate 23b come into electrical contact with the transistor component 10 which is supported on the base-plate 23a; and thereby configuring the nest 21 to have an "closed" configuration (as is shown in Figure 3d). Specifically, the cover-plate 23b is moved so that the source and the gate of the transistor component 10 are in electrical connection with second set of electrical contacts 43 on the cover-plate 23b. Thus at this stage the drain of the transistor component 10 is in electrical connection with the first set of electrical contacts 33 on the base plate 23a and the source and the gate of the transistor component 10 are in electrical connection with second set of electrical contacts 43 on the cover-plate 23b. Figure 3e provides an illustration of the follower 51 when the nest 21 has been configured to have a "closed" configuration.

Since, at the third station 21c the plate member 300 of the second cam 52b was rotated to move the first projection member 63a to the level of the lower track 60a, the subsequent rotation of the satellite table 22 to bring the nest 21 to the fourth position 21d (i.e. rotation to bring the nest to the fourth station 21d of the satellite table 22) along the testing assembly 20, will move the first projection member 63a out of the cut-out 163 of the rotatable plate member 300 of the second cam 52b and onto the lower track 60a; the first projection member 63a will remain supported on, and will move along, the lower track 60a through subsequent rotations of the satellite table 22, until the first projection member 63a reaches the station 8 where the first cam 52a is located. As the first projection member 63a remains supported on, and moves along, the lower track 60a the cover-plate 23b is maintained in its horizontal orientation i.e. the nest 21 is maintained in its closed configuration wherein both the first set of electrical contacts 33 on the base plate 23a and the second set of electrical contacts 43 on the cover-plate 23b are electrical contact with the transistor component 10. Thus at the fourth position 21d the nest will be in a "closed" configuration, with the member 63 supported on the lower track 60a thus maintaining the cover-plate 23b in a horizontal orientation and in a position wherein the second set of electrical contacts 43 on the cover-plate 23b are in electrical contact with the transistor component 10.

At the fourth position 21d i.e. fourth station 21d of the satellite table 22) there is provided a first camera 81a which is used to capture a first image; the first image provides a side view of the base-plate23a, cover-plate 23b and transistor component 10 in the closed nest 21 is captured by a first camera 81a. Thus first image is captured by the first camera 81a after nest has been configured by the second cam 52b at the third position 21c to have a closed configuration. The first image is used to verify that the transistor component 10 is in a predefined position; specifically, the first image is used to verify that all of the electrical contacts in the first and second sets of electrical contacts 33,43 provided respectively on the base-plate 23a and cover-plate 23b, are in electrical contact with the transistor component 10. This is done by checking the first image to make sure that all of said plurality of electrical contacts on the base-plate 23a of nest 22 underlay the transistor component 10, and all of said plurality of electrical contacts on the cover-plate 23b of nest overlay transistor component 10. This is important because if the transistor component 10 is in such a position whereby one or more of the electrical contacts on the base-plate 23a or cover-plate 23b is offset from the transistor component 10 (i.e. does not electrically contact the transistor component 10) then the transistor component 10 will become damaged when that electrical contact conducts a high current (e.g. due to discharge arcing).

The first camera 81a and a first light source 82a is provided at the fourth position 21d; the first camera 81a is used to capture the first image whereby the first light source 82a is used to provide the necessary light when capturing the first image. The first camera 81a and a first light source 82a are located above the nest 22 which is located at the fourth position 21d. The first light source 82a will exhibit light rays which pass through two of the apertures 25a,b which are defined in the cover-plate 23b of the nest 22. The light rays will be incident on two respective reflective elements 24a,b which the apertures 25a,b overlay, and will be reflected by the reflective elements 24a,b towards the transistor component 10 and the platforms 28,29 of the respective base-plate 23a and cover-plate 23b. The light which is not incident on the platforms 28,29 and transistor component 10 will be incident on the other two respective reflective elements 24c,d, and this light will be reflected by these other two respective reflective elements 24c,d towards the first camera 81a. The light received by the first camera 81a is then used to generate the first image. The light which is incident on the platforms 28,29 and transistor component 10 will be blocked from passing to the reflective elements 24c,d and thus will not be received into the first camera. Accordingly, the first image will be a silhouette of the transistor component 10 and the platforms 28,29 of the respective base-plate 23a and cover-plate 23b.

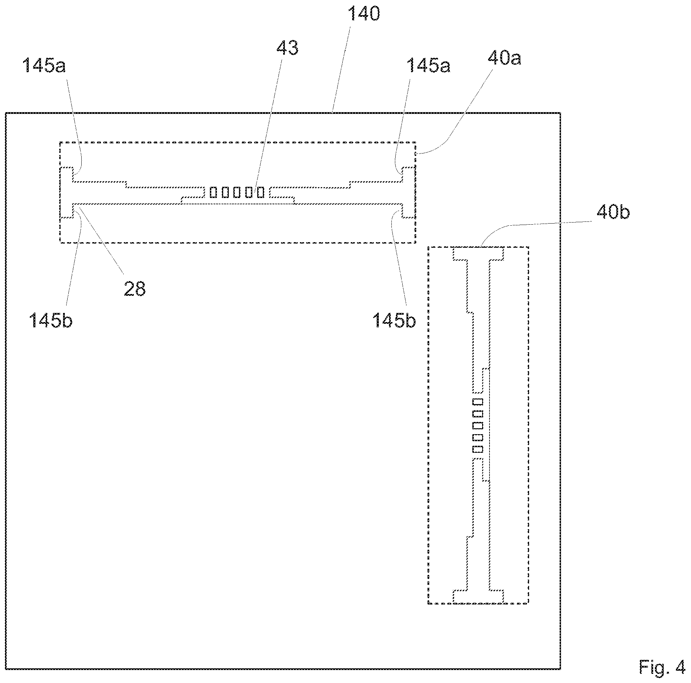

Figure 4 provides an example of the first image 140 which is captured by the first camera 81a. The first image 140 includes two side views 40a,40b, perpendicular to one another, of the transistor component 10 and the platforms 28,29; the side views 40a,40b. The light which was reflected by the reflective element 24c towards the first camera will result in a first side view 40a in a first direction, and light which was reflected by the reflective element 24d towards the first camera will result in a second side view 40b in a second direction which is perpendicular to the first direction.

The first image 140 shows the silhouette of the platform 28 of the base-plate 23a and the silhouette of the platform 29 of the cover-plate 23b, and the silhouette of the transistor component 10, and the silhouette of the electrical contacts belonging to the second set of electrical contacts 43 on the cover-plate 23b.

As can be seen from Figure 4, the shape of the raised platforms 28,29 (i.e. square with projecting members at each side of the square) provide reference elements 145a,145b in the first image 140 which allow to easily identify from the first image 140 the positions of the base-plate 23a and cover-plate 23b with respect to one another. Reference elements 145a are formed by the raised platform 28 on the cover plate 23b, and the reference elements 145b are formed by the raised platform 29 on the base plate 23a. In the present example the first image 140 is inspected to identify if the reference elements 145a,b are aligned in the first image 140; if the reference elements 145a,b are aligned then it is determined that the base-plate 23a and cover-plate 23b are aligned with one another; if the reference elements 145a,b are not aligned then it is determined that the base-plate 23a and cover-plate 23b are out of alignment. If the reference elements 145a,b are not aligned so that it is determined that the base-plate 23a and cover-plate 23b are out of alignment, the high current testing process is interrupted and the base-plate 23a and cover-plate 23b are adjusted to as to bring them into alignment. Preferably, the base-plate 23a and cover-plate 23b of each nest are aligned in a calibration step which is carried out prior to beginning the high current testing process; and the first image 140 which is captured during the high current testing process is used then to verify that the base-plate 23a and cover-plate 23b have not moved out of alignment. In the calibration step the base-plate 23a and cover-plate 23b of each nest are moved along the x,y and z-axes, as is necessary, to bring them into alignment.

Also, in this example the first image is inspected check that the second set of electrical contacts 43 on cover-plate 23b electrically contact the transistor component 10 (and preferably also to check that the first set of electrical contacts 33 on the base plate 23a); this is done by checking in the first image 140 for the presence of a gap between the second set of electrical contacts 43 and the transistor component 10; if the first image 140 shows a gap between the between the second set of electrical contacts 43 and the transistor component 10 then it can be determined that the second set of electrical contacts 43 do not properly electrically contact the transistor component 10 (this can occur if for example the electrical contacts 43 become worn down). If it is determined that the second set of electrical contacts 43 do not properly electrically contact the transistor component 10 then the position of second set of electrical contacts 43 can be adjusted using the screw 71 to move the platform 70 towards the cover plate 23b thereby moving the transistor component 10 towards the second set of electrical contacts 43. In yet another embodiment the distance 'd' between the silhouette of the platform 29 of the cover-plate 23b and the silhouette of the transistor component 10 is measured; the measured distance 'd' can then used to determine the distance which the second set of electrical contacts 43 on the cover-plate 23b penetrate into the source and gate of the transistor element 10.

In the most preferred embodiment in said calibration step which is carried out prior to beginning the high current testing process, the amount which the second set of electrical contacts 43 on the cover-plate 23b penetrate into the source and gate of the transistor element 10 is set; this is done by a user positioning a component on the base-plate 23a so that the component is in electrical connection with the first set of electrical contacts 33 on the base plate 23a, and then moving the cover plate 23b so that it overlays the base-plate 23a and the second set of electrical contacts 43 on the cover plate 23b are in electrical contact with the component. The user then moves the cover plate 23b away from the base plate 23a and removes the component from the nest, and inspects the surface of the component under a microscope. If the inspection shows that the surface of the component has been marked or damaged by the second set of electrical contacts 43 on the cover plate 23b then the screw 71 at that nest is adjusted to move the platform 70 away from the cover plate 23b (i.e. to lower the platform 70) thereby decreasing the distance which the electrical contacts 43 on the cover-plate 23b penetrate into the source and gate of the component; the user repeats the above steps until the platform 70 has reached a position which will allow the second set of electrical contacts 43 on the cover plate 23b to electrical contact the component without damaging or marking the component. These steps are carried out for each of the nests 21 in the assembly 1. Thus each nest in the assembly is calibrated to ensure that the second set of electrical contacts 43 on the cover plate 23b penetrate the component by the desired distance when the cover plate 23b is moved to overlay the base plate 23a during the high current testing process. During the high current testing process the first image 140 is used to verify that the second set of electrical contacts 43 on the cover plate 23b have not become worn so that they fail to make electrical contact with the component; if this is the case then the process is interrupted and the above-mentioned calibration steps are performed once again.

Also in this example a first distance 'R1' between the silhouette of base-plate 23a and the silhouette of the cover-plate 23b on one side of the transistor component 10 is inspected and a second distance 'R2' between the silhouette of base-plate 23a and the silhouette of the cover-plate 23b on a second, opposite, side of The transistor component 10 is inspected. A user then determines, based on their visual inspection of the first image 140, if there is a difference between the first and second distances (R1,R2). If there is a noticeable difference between the first and second distances (R1,R2) then the user may decide that the cover-plate 23b and base-plate 23a are not sufficiently parallel to one another. In yet another embodiment a processor processes the first image 140 and measures the first distance 'R1' and the second distance 'R2'; the processor determines the difference between the first and second distances (R1,R2) an compares the difference to a threshold distance; if the difference differs from the threshold distance by an amount which is above a predefined threshold amount then it is determined that the cover-plate 23b and base-plate 23a are not sufficiently parallel to one another.

If there is a noticeable difference between the first and second distances (R1,R2) then the user may decide that the cover-plate 23b and base-plate 23a are sufficiently parallel and the testing process continues. In the present invention, if it is determined that the cover-plate 23b and base-plate 23a are not sufficiently parallel to one another (for example if the difference between the first and second distances (R1,R2) is larger than a predefined distance, then the user may decide that the cover-plate 23b and base-plate 23a are not sufficiently parallel) then the process is interrupted and the orientations of the base-plate 23a and/or cover-plate 23b are adjusted to as to make the plates parallel to one another. Preferably, the base-plate 23a and cover-plate 23b of each nest are orientated to be parallel in the afore-mentioned calibration step which is carried out prior to beginning the high current testing process; the first image 140 which is captured during the high current testing process is used then to verify that the base-plate 23a and cover-plate 23b have not moved from their parallel orientations. In the calibration step the base-plate 23a and cover-plate 23b of each nest are moved along the x,y and z-axes, as is necessary, to bring them into alignment, and also to bring them into an orientation in which they are parallel to one another.

Inspecting first and second distances (R1,R2) and the distance 'd' also allows the user to identify if there has been any degradation or wearing of the cover plate or base plate; thus the user can determine, based on their inspection of the first image if the first and/or second sets of electrical contacts 33,43 and/or the cover-plate 23b, and/or the base plate 23a needs to be replaced.

Additionally, at the fourth position 21d, and also each of the At the fifth, sixth and seventh positions 21e-g (i.e. fourth, fifth, sixth and seventh stations 21d-g of the satellite table 22) high current testing of the transistor component 10 is carried out; specifically high current is supplied to the transistor component 10 and the performance of the transistor component 10 when the high current is applied, is monitored. Thus, in this particular example at the fourth position 21d, both a first image is captured using the first camera 81a and also high current testing of the transistor component 10 is carried out; in this example the high current testing of the transistor component 10 is carried out at the fourth position 21d only after the first camera 81a has captured the first image.

At each of the fourth, fifth, sixth and seventh positions 21d-g there is provided a upper set of electrical contacts 50a, and a lower set of electrical contact 50b. Each of the upper and lower sets of electrical contacts 50a,50b are electrically connected to a current source 35 which can supply high current.

The lower set of electrical contacts 50b, can be selectively moved to make electrical contact with the first PCB board of the base-plate 23a. After the lower set of electrical contacts 50b has been moved to make electrical contact with the first PCB board 34 of the base-plate 23b, the current source 35 which is connected to the lower set of electrical contacts 50b is then operated to supply high current to the lower set of electrical contacts 50b; the high current passes from the lower set of electrical contacts 50b to the first PCB board of the base-plate 23a, and in turn is conducted to the drain of the transistor component 10 via the first set of electrical contacts 33 of the base-plate 23a.

The upper set of electrical contacts 50a, can be selectively moved to make electrical contact with the second PCB board 44 of the cover-plate 23b. After the upper set of electrical contacts 50a has been moved to make electrical contact with the second PCB board of the cover-plate 23b, the current source which is connected to the upper set of electrical contacts 50a is then operated to supply high current to the upper set of electrical contacts 50a; the high current passes from the upper set of electrical contacts 50a to the second PCB board 44 of the cover-plate 23a, and in turn is conducted to the gate and source of the transistor component 10 via the second set of electrical contacts 43 of the cover-plate 23a.

In this embodiment each of the transistor components 10 which are located at the respective fourth, fifth, sixth, and seventh positions 21d-g (i.e. fourth, fifth, sixth and seventh stations 21d-g of the satellite table 22) are tested in parallel; accordingly in this embodiment the satellite table 22 rotates three iterations so that a respective transistor component 10 can be delivered to each of the nests located at the fourth, fifth, sixth, and seventh positions 21d-g, before the lower set of electrical contacts 50b at each of the fourth, fifth, sixth and seventh positions 21d-g are moved to make electrical contact with the first PCB board of the base-plate 23a and upper set of electrical contacts 50a at each of the fourth, fifth, sixth and seventh positions 21d-g are moved to make electrical contact with the second PCB board 44 of the cover-plate 23b. The high current may subsequently be supplied simultaneously to the respective transistor components 10 located in on the nests at the fourth, fifth, sixth and seventh positions 21d-g.

In one embodiment the same parameter of the respective transistor components 10 is measured at each of the fourth, fifth, sixth and seventh positions 21d-g; in another embodiment a different parameter of the respective transistor components 10 is measured at the fourth, fifth, sixth and seventh positions 21d-g.

After the high current has been supplied to the transistor components 10 at each of the fourth, fifth, sixth and seventh positions 21d-g, and before the satellite table 22 is rotated to bring the respective transistor components 10 to their respective 'next' positions 21e-h, the upper and lower sets of electrical contacts 50a,50b are moved away from the first and second PCB boards 33,43. This is to allow a clearance gap so that the upper and lower sets of electrical contacts 50a,50b do not interfere with the rotation of the satellite table 22.

At the eight position 21h (i.e. eight station 21h of the satellite table 22) the nest 21 is opened i.e. the cover-plate 23b is moved away from the base-plate 23a so that the electrical contacts on the cover-plate 23b are no longer in contact with the transistor component. Specifically, the first cam 52a is located at the eight position 21h, and is operated to configure the nest 21 which is located the eight position 21h to have an "open" configuration.

The rotation of the satellite table 22 to bring the nest from the seventh position 21g to the eight position 21h will move the first projection member 63a of the nest into the cut-out 163 of the rotatable plate member 300 in the first cam 52a. The sensor 303 of the first cam 52a will detect that a first projection member 63a of a nest 21 has been received into a cut-out 163 of the rotatable plate member 300; in response the sensor 303 will initiate the motor 301 to rotate the plate member 300. As the plate member 300 is rotated it will move the first projection member 63a, in an arch, from the level of the lower track 60a to the level of the upper track 60b. As the plate member 300 rotates to move the first projection member 63a, in an arch, from the level of the lower track 60a to the level of the upper track 60b, this will cause the second projection member 63b to push upwards against the track member 364; the second projection member 63b will also roll horizontally along the groove of the track member 364 (in this example it will roll from right to left). The upward force which the second projection member 63b applies to the track member 364 will cause the follower 51 to move upwards thereby moving the cover-plate 23b into a vertical orientation; and thereby configuring the nest 21 to have an "open" configuration (as is shown in Figure 3b). Specifically, upward force which the second projection member 63b applies to the track member 364 of the first cam 42a will cause the follower 51 to move upwards thereby, moving the cover-plate 23b firstly away from the base-plate 23a in a horizontal orientation so that the electrical contacts 43 on the cover-plate 23b are no longer contact the transistor component 10, and then moving the cover-plate 23b from its horizontal orientation into a vertical orientation. Figure 3c provides an illustration of the follower 51 when the nest 21 has been configured to have an "open" configuration.

Since the plate member 300 rotates to move the first projection member 63a to the level of the upper track 60b, the subsequent rotation of the satellite table 22 to bring the nest 21 to the next position along the testing assembly 20 (i.e. the rotation of the satellite table 22 to bring the nest 21 to the ninth position 21i), will move the first projection member 63a out of the cut-out 163 of the rotatable plate member 300 and onto the upper track 60b; the first projection member 63a will remain supported on, and will move along, the upper track 60b through subsequent rotations of the satellite table 22, at least until the first projection member 63a reaches the third position 21c again where the second cam 52b is located (at which point the nest will be configured again by the second cam 52b to have a "closed" configuration). As the first projection member 63a remains supported on, and moves along, the upper track 60b the cover-plate 23b is maintained in its vertical orientation i.e. the nest 21 is maintained in its open configuration.

At the ninth position 21i (i.e. ninth station 21i of the satellite table 22) inspection of transistor component 10 is carried out to determine if the transistor component 10 has become damaged during the preceding steps. A second camera 81b and second light source 82b is provided at the ninth position 21i; the second camera 81b is used to capture a second image of the transistor component 10 as it rests on the base plate 23b of the nest 21, and wherein the second light source 82b provides the necessary lighting for capturing the second. The second camera 81b is configured to capture a magnified view of the transistor component 10 (i.e. the second image will provide a magnified view of the transistor component) (e.g. by having appropriate lens, and focus settings). Since the nest 21 was opened at the preceding eight position 21h, and the projecting member 63 of the nest 21 is in the upper track 60b thus maintaining the nest 21 in its open configuration, the transistor component 10 in the nest 21 is thus exposed enabling the second camera 81b to capture the second image of the transistor component 10. The second light source 82b emits light towards the base-plate 23a; the transistor component 10 on the base-plate 23a reflects a portion of the light into the second camera 81b and the second camera 81b generates the second image using the light which it receives. The second image is inspected to determine if the transistor component 10 was damaged (e.g. to determine if there are any cracks in the transistor component). Typically, the transistor components will be too small to manually inspect; advantageously, the second image will provide a magnified view of the transistor component 10, thus allowing more accurate inspection of the transistor component 10.

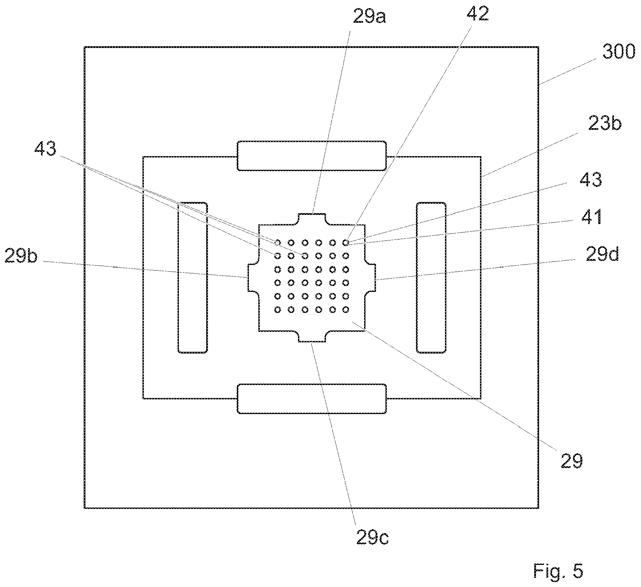

At the tenth position 21j (i.e. i.e. tenth station 21j of the satellite table 22) the position of the second set of electrical contacts 43 on cover-plate 23b is determined. A third camera 81c is provided at the tenth position 21j; the third camera 81c is used to capture a third image of the cover-plate 23b. The position of the second set of electrical contacts 43 on cover-plate 23b is identified from the third image. Figure 5 is an example of a third image 300 of the cover plate 23b.

The third image 300 shows the cover-plate 23b with its raised platform 29 which is square and with projecting portions 29a-d at each respective side of the square. The central region of the raised platform 29 comprises a plurality of holes 41, each of which can receive an electrical contact 42; an electrical contact 42 is provided in each hole 29, so as to define a second set of electrical contacts 43. By visual inspection of the third image 300, the position of the second set of electrical contacts 43 on the cover-plate 23b can be determined. This step is preferred because the second set of electrical contacts 43 may not be centred on the cover-plate 23b due to manufacturing tolerances and/or variations or errors in the manufacture of the cover plate 23b.

As already mentioned at the first position 21a (i.e. first station 21a of the satellite table 22) the transistor component 10, which can already passed though each of the preceding positions 21a-j (and thus has already undergone testing under high current conditions) is transferred back to a component handling head 5 on the turret 3. At the first position 21a the transistor component 10 is picked, by a respective component handling head 5 on the turret 3, from the base-plate 23a of the nest 21. After the transistor component 10 has been picked the turret 3 will then rotate to transport the picked transistor component 10 to the next station 8 in the component handling assembly 1. The rotation of the turret 3 brings the next component handling head 5 (which carries another transistor component 10 which is due to be tested) to above the empty nest 21; said next component handling head 5 then delivers the transistor component 10 which it carries to the nest 21.

Referring back to the ninth position 21i, it should be noted that, during said afore-mentioned calibration step which is carried out prior to beginning the high current testing process (and thus which takes place before components are provided in any of the nest 21 so that each of the nests 21 are empty) the second camera 81b at the ninth position 21i is used to capture an image (fourth image) of the base-plate 23b of each nest. The position of the first set of electrical contacts 33 on the base-plate 23a of each nest is identified from the respective fourth images of each nest 21.

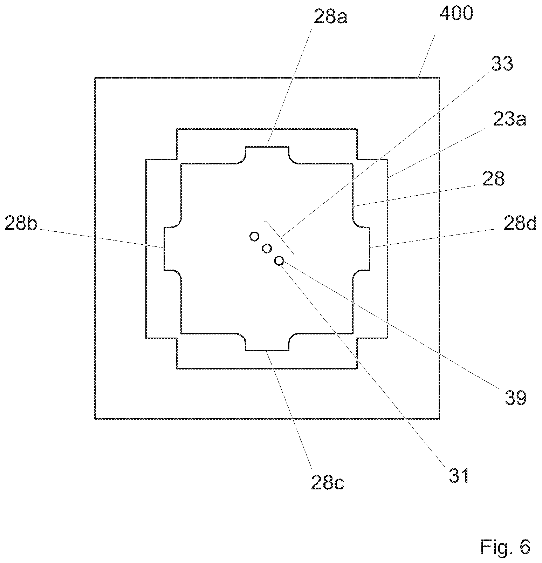

Referring to figure 6, the fourth image 400 is shown to depict the base plate 23a.The base-plate 23a comprises a raised platform 28 which is square and with projecting portions 28a-d at each respective side of the square. The central region of the raised platform 28 comprises a plurality of holes 39, each of which can receive an electrical contact 31. In this example an electrical contact 31 is provided in each hole, so as to define a first set of electrical contacts 33. By visual inspection of the fourth image 400, the position of the first set of electrical contacts 33 on the base-plate 23a can be determined. This step is preferred because the first set of electrical contacts 33 may not be centred on the base-plate 23b due to manufacturing tolerances and/or variations or errors in the manufacture of the base plate 23a.

When a high current (e.g. between 200-300amp) is input to the component at the fourth, fifth, sixth and seventh positions 21d-g, it is important that the electrical contacts 33 on the base-plate 23a all contact the drain of the transistor component 10, and the electrical contacts 43 on the cover-plate 23b contact the gate or source of the transistor component 10; in other words it is important that none of the electrical contacts 33 on the base-plate 23a, and none of the electrical contacts 43 on the cover-plate 23b, do not make electrical contact with either the drain, gate or source of the transistor component 10. Otherwise the transistor component 10 under test will become damaged when the high current is input (e.g. due to arc discharge which may occur). Accordingly it is important that the transistor component 10 is placed into a predefined position on the nest 21 whereby all of the electrical contacts in the first set of electrical contacts 33 on the base-plate 23a of the nest 21 make electrical contact with the drain of the transistor component 10; and some of the electrical contacts in the second set of electrical contacts 43 on the cover-plate 23b of the nest 21 make electrical contact with the gate, and, the remaining electrical contacts in the second set of electrical contacts 43 on the cover-plate 23b of the nest 21 make electrical contact with the source of the transistor component 10, when the nest 21 is closed. However, the positions of the second set of electrical contacts 43 on the cover-plate 23b may differ between nests, and/or the positions of the first set of electrical contacts 33 on the base-plate 23a may differ between nests, and/or the positions of the gate, source and drain in the transistor component may differ between transistor components 10 (e.g. due to wafer cutting tolerances); accordingly, each transistor component 10 may require a different predefined position on the nest 21 (depending on the positions of the gate, source and drain of the component, and depending on the positions of the first and second set of electrical contacts in the respective base-plate 23a and cover-plate 23b of the nest into which that transistor component is to be placed for high current testing) in order to ensure that all of the electrical contacts in the nest establish electrical contact with the transistor component 10.

One of the stations 8 in the component handling assembly 1 is an inspection station; the inspection station comprises a fourth camera 81e which is used to capture an image of the transistor component 10. In one embodiment the fourth camera 81e is configured to capture an image (fifth image) of the transistor component 10 while it is held by a component handling head on the turret; in another embodiment the component handling head 5 delivers the transistor component 10 to a stage in the inspection station and the fourth camera 81e then captures a fifth image of the transistor component 10 when it is resting on the stage.

The locations of the source and the gate of the transistor component 10 are identified from the fifth image. The position of the drain can be determined based on the position of the source and gate, since the drain will simply underlay the source and gate. This is necessary because the transistor component 10 typically will have come from a wafer which has been cut; since there is some tolerance in the cutting of the wafer, the exact positions of the gate and source may differ slightly between transistor components.

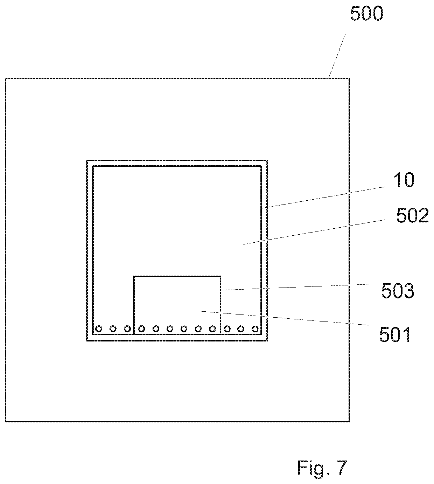

Figure 7 provides an example of a fifth image 500. As can be seen, the locations of the gate 501 and source 502 in the transistor component 10 can be easily identified from the fifth image 500, as a distinct interface 503 appears in the fifth image 500 between the gate and source. The position of the drain can be determined based on the position of the source 502 and gate 501; the drain will simply underlay the source 502 and gate 501.

Another one of the stations 8 in the component handling assembly 1 comprises an alignment device 15 which is operable to move the transistor component 10 held by the component handling head 5 which is located at said station 8 into a predefined position on the component handling head 5. The station 8 in the assembly 1 which comprises the alignment device 15 is preferably the station 8 which is immediately preceding (in the direction of rotation of the turret 3) the station 8 where the component is delivered to the nest 21 of the satellite table 22. Thus the transistor component 10 is aligned into a predefined position on the component handling head 5 immediately prior to delivering the component to the testing assembly 20.

The predefined position on the component handling head 5 into which the alignment device 15 aligns the component 10 is a position such that when the transistor component 10 the component handling head 5 delivers the transistor component 10 to the nest 21 of the satellite table 22 the transistor component 10 will be placed at a position wherein all of the electrical contacts in the first set of electrical contacts 33 on the base-plate 23a of the nest 21 make electrical contact with the drain of the transistor component 10; and such that when the nest 21 is in its closed configuration, some of the electrical contacts in the second set of electrical contacts 43 on the cover-plate 23b of the nest make electrical contact with the gate, and, the remaining electrical contacts in the second set of electrical contacts 43 on the cover-plate 23b of the nest will make electrical contact with the source of the transistor component 10.

The alignment device 15, determines said predefined position on the component handling head 5 which each transistor should have. The alignment device 15 receives the fifth image 500 from the fourth camera 81e, receives from the second camera 81b the fourth image 400 of the base-plate 23a of the nest 21 (which was captured during the calibration step) in which said transistor component 10 is due to be placed, and receives from the third camera 81c the third image 300 of the cover-plate 23b of the nest 21 in which said transistor component 10 is due to be placed. The alignment device 15 uses the fifth image 500 to identify the locations of the source 502 and the gate 501 (and drain) of the transistor component 10, uses the fourth image 400 to identify the position of the first set of electrical contacts 33 on the base-plate 23a of the nest 21 which the transistor component 10 is due to be placed, and uses the third image 300 to identify the position of the second set of electrical contacts 43 on the cover-plate 23b of the nest 21 which the transistor component 10 is due to be placed. The alignment device 15 determines said predefined position on the component handling head 5 which each transistor should have based on the identified positions of, the source 502 and the gate 501 (and drain) of the transistor component 10, the first set of electrical contacts 33 on the base-plate 23a of the nest which the component is due to be placed, and the second set of electrical contacts 43 on the cover-plate 23b of the nest which the component is to be placed. The alignment means 15 is then operated to move the component into said predefined position on the component handling head 5. The alignment means 15 will preferably have an arm which moves the transistor component 10 into the predefined position on the component handling head 5 while the transistor component 10 is being held by the component handling head 5; in other words the transistor component 10 is aligned to the predefined position without releasing the transistor component 10 from the component handling head 5. In another embodiment the transistor component 10 is delivered by the component handling head 5 to an x-y table and the x-y table is then moved to bring the transistor component 10 to a position such that when the component handling head 5 picks the component from the x-y table the transistor component 10 will occupy said predefined position on the component handling head.

During the afore-mentioned calibration step which is carried out prior to beginning the high current testing process the position of the fourth camera 81e, and the base plate 23a of each respective nest 21, and the alignment means are all set to reference start position within a predefined frame of reference; this is preferably done using an alignment jig. For example, a grid defining a frame of reference may be used; the grid is positioned in the view of the fourth camera 81e and the fourth camera 81e is moved until the centre of the image captured by the fourth camera 81e overlays the centre of the grid; the alignment means 15 is then moved so that it is aligned with the centre of the grid; thus the alignment means 15 and fourth camera 81e will be aligned using the grid.

In addition, during the afore-mentioned calibration step, the second camera 81b which is located at the ninth position 21i, is aligned using the grid (or using some other suitable reference); the grid is positioned on the base plate 23a of the nest which is located at the ninth position 21i (i.e. the ninth station 21i of the satellite table 22); the position of the second camera 81b is then adjusted so that a centre of the field of view of the second camera 81b is aligned with a centre of the grid. Each of the second camera 81b, the alignment means 15, and fourth camera 81e, are aligned to the centre of the same grid therefore the second camera 81b, the alignment means 15, fourth camera 81e all have the same reference position with respect to the frame of reference which is defined by the grid. Each of the nests on the satellite table is aligned using the second camera 81b (which is downward looking) at the ninth position 21i. Specifically the base plate 23a of the nest which is located at the ninth position 21iis moved to a position where the centre of the base plate 23a is aligned with the centre of the field of view of the second camera 81b; each of the nests are aligned in this manner; specifically each nest on the satellite table is moved consecutively to the ninth position 21iand at that position the base plate 23a of the nest is moved to a position where the centre of the base plate 23a is aligned with the centre of the field of view of the second camera 81b. It should be understood that the grid may take any suitable form; for example, the grid may be a Y-marker.

In an alternative embodiment, instead of aligning each nest using the second camera 81b, each nest is aligned using the grid; in this alternative embodiment the gird is moved to each respective nest 21, at each nest the base plate 23a of the nest is moved to a position where the centre of the base plate 23a is aligned with the centre of the grid (the centre of the base plate 23a is typically identified as being the point at the centre of the raised platform 28 (i.e. not necessarily the centre of the first set of electrical contacts 33 on the base plate 23a).

In an embodiment, the second camera 81bis used to capture a fourth image 400 of the base-plate 23a of a nest 21 during the calibration step; from the fourth image 400 the centre of the first set of electrical contacts 33 is identified (this can be done using known image processing techniques). The offset between the centre of the first set of electrical contacts 33 and the centre of gravity of base plate 23a is determined from the fourth image 400. The alignment means 15 adjusts the orientation of the transistor component 10, which is destined to be delivered to the nest 21 to which the base-plate 23a in the fourth image 400 belongs, on the component handling head 5 to compensate for said offset. Accordingly, when the component is delivered to said nest 21 the component will be delivered into a position where it will establish electrical contact with all of the electrical contacts in the first set of electrical contacts 33 provided on the base plate (the position into which the component is delivered will not correspond to the centre of gravity of the nest if there is an offset between the centre of the first set of electrical contacts 33 and the centre of gravity of base plate 23a). This is done for each respective component held by the component handling heads 5 of the turret; in other words, using the fourth image 400 of the base plate 23a of each respective nest, the alignment means 15 adjusts the orientation of each of the respective transistor components 10 on the component handling head 5 to compensate for the offset between the centre of the first set of electrical contacts 33 and the centre of gravity of the base plate 23a of the nest 21 to which that respective component is to be delivered; in this way each transistor component 10 is moved into their respective predefined positions on the component handling heads 5.

In a further embodiment the fifth image could be used for sawing issue and verify we are contacting properly. It could be that the device is not sawn properly and the contacting areas (drain, source, gate) are not located to the theoretical position referring the device outlines. Since fourth camera 81econsiders the device outlines only to place it properly into the test nest we would need to incorporate this new offset into the computation of correction done by alignment device 15.

Accordingly in the present invention the transistor component is aligned into a predefined position on the component handling head, prior to delivering the transistor component to the nest on the satellite table, using image data depicting the positions of the electrical contacts in the nest which is due to receive the component and image data depicting the positions of the source and gate of the transistor component, to ensure that when the component is subsequently delivered to the nest by the component handling head the component will occupy a position such that all of the electrical contacts in the nest electrically contact the transistor component (i.e. some of electrical contacts in the nest electrically will contact the gate of the transistor component; some of electrical contacts in the nest electrically will contact the source of the transistor component; and the remaining electrical contacts in the nest will electrically contact the drain of the transistor component). Accordingly none of the electrical contacts in the nest will not electrically contact the transistor component, so that the risk of damage occurring to the component during high current testing (e.g. due to arch discharge) is reduced.

## Claims

1. A method of testing a transistor component (10), the method comprising the step of,
(a) capturing a first image of the transistor component (10) which is to be positioned into a nest (21) for testing;
(b) identifying from the first image the locations of the source and gate of the transistor component (10);
(c) holding the transistor component (10) using a component handling head (5) on a rotatable turret (3),
(d) using an alignment device (15) to move the transistor component (10) into a position on the component handling head (5) such that the component handling head (5) can deliver the component (10) into a position on the nest (21) wherein all of a plurality of electrical contacts (33) on the base-plate (23a) of the nest (21) will make electrical contact with the drain of the transistor component, and a portion of the plurality of electrical contacts (43) on the cover-plate (23b) of the nest (21) will make electrical contact with the gate of the transistor component (10) and the remaining electrical contacts (43) on the cover-plate (23b) of the nest (21) will make electrical contact with the source of the transistor component (10), when the cover-plate (23b) is moved to close the nest (21);
(e) delivering the transistor component (10) to the nest (21) so that all of said plurality of electrical contacts (33) on the base-plate (23a) of the nest (21) make electrical contact with the drain of the transistor component (10);
(f) moving the nest cover-plate (23b) to overlay the base-plate (23a) to close the nest (21) and a portion of the plurality of electrical contacts (43) on the cover-plate (23b) of the nest (21) will make electrical contact with the gate of the transistor component (10) and the remaining electrical contacts (43) on the cover-plate (23b) of the nest (21) will make electrical contact with the source of the transistor component (10);
(g) performing testing of the transistor component (10);
(h) capturing a second image of the nest (21) when the nest (21) is closed, the second image providing a side view of the cover-plate (23b) , base-plate (23a) , and transistor component (10); and
(i) using the second image to determine if all of said plurality of electrical contacts (33) on the base-plate (23a) of the nest (21) overlay the drain of the transistor component (10), and to determine if said remaining electrical contacts (43) on the cover-plate (23b) of the nest (21) overlay the source of the transistor component (10).

2. A method according to claim 1 further comprising the step of inspecting the second image to determine if there is a gap between the electrical contacts on the cover-plate of the nest and the transistor component.

3. A method according to claim 2 further comprising the step of moving the position of the base-plate towards the cover-plate if it is determined from the second image that there is a gap between the electrical contacts on the cover-plate of the nest and the transistor component, until the transistor component is moved to close the gap so that the transistor component electrically contacts the electrical contacts on the cover-plate.

4. A method according to claim 1 further comprising the step of inspecting the second image to determine if the distance 'R1' between the base-plate and the cover-plate on one side of the transistor component differs from the distance 'R2' between the base-plate and cover-plate on a second, opposite, side of the transistor component.

5. A method according to any one of claims 1-4 wherein the second image is captured by,
passing light through windows in the cover plate;
reflecting the light which has passed through the windows to the component, cover-plate and base-plate, using reflective elements on the base plate;
receiving into camera, via other windows in cover member, light which was reflected by the component, cover-plate and base-plate.

6. A method according to any one of the preceding claims further comprising steps of,
capturing an image of the plurality of electrical contacts provided on the base-plate of the nest, and determining from the image the position of the electrical contacts provided on the base-plate of the nest; and
capturing an image of the plurality of electrical contacts provided on the cover-plate of the nest, and determining from the image the position of the electrical contacts provided on the cover-plate of the nest; and
capturing an image of the transistor component which is due to be delivered to said nest, and determining at least locations of the source and gate of the transistor component from said image of a transistor component;
determining from said image of the plurality of electrical contacts provided on the base-plate of the nest, said image of the plurality of electrical contacts provided on the cover-plate of the nest, and said image of the transistor component which is due to be delivered to said nest, said position on said component handling head into which the alignment device should move the component in step (d).

7. A testing assembly which can be used to carry out a method according to claim 1, the testing assembly comprising
a turret (3) having a plurality of component handling heads (5) which can each carry a transistor component (10);
an alignment device (15) which can move a transistor component (10) into a predefined position on the component handling head (5);
a satellite table (22) which comprises a plurality of nests (21), wherein each nest (21) comprises a base-plate (23a) and a cover-plate (23b);
a camera (81b) which is arranged to capture an image of the base plate (23a) of a nest (21) wherein said image can be used to determine the position of electrical contacts (33) on the base plate (23a); a camera (81c) which is arranged to capture an image of the cover plate (23b) of the nest (21) wherein said image can be used to determine the position of electrical contacts (43) on the cover plate (23b); a camera (81e) which is arranged to capture an image of the component (10) which is due to be delivered to the nest (21); a camera (81a) which is arranged to capture an image of a nest (21) when the nest (21) is closed, the image providing a side view of the cover-plate (23b), base-plate (23a), and transistor component (10); wherein said alignment device (15) is configured to receive said images, and based on the images move the transistor component (10) into a position on the component handling head (5) such that the component handling head (5) can deliver the component (10) into a position on the nest (21) wherein all of said plurality of electrical contacts (33) on the base-plate (23a) of the nest (21) will make electrical contact with the drain of the transistor component (10), and a portion of the plurality of electrical contacts (43) on the cover-plate (23b) of the nest (21) will make electrical contact with the gate of the transistor component (10) and the remaining electrical contacts (43) on the cover-plate (23b) of the nest (21) will make electrical contact with the source of the transistor component (10), when the cover-plate (23b) is moved to close the nest (21).

8. A testing assembly according to claim 7 wherein the base-plate comprises a raised platform which is substantially square and with projecting portions at each respective side of the square; and the cover-plate comprises a raised platform which is square and with projecting portions at each respective side of the square.

9. A testing assembly according to claim 7 or 8 wherein the base plate comprises a plurality of reflective elements which are angled relative to the plane of the base-plate; and the cover-plate comprises a corresponding plurality of apertures defined therein, such that when the cover-plate is arranged to overlay the base-plate each aperture overlays a respective reflective element.

10. A testing assembly according to any one of claims 7-9 wherein the cover-plate is pivotally mounted on a follower which can cooperate with a cam; wherein moving the follower in a first direction will cause the cover-plate to pivot away from the base plate, and moving the follower in a second direction will cause the cover-plate to pivot towards from the base plate.

11. A testing assembly according to claim 10 wherein the follower comprises an actuator member which comprises first and second projection members which project in opposite directions; wherein the first projection member rests on and can moves an upper or lower track as the satellite table rotates, and can cooperates with a cam.

12. A testing assembly according to claim 11 wherein the follower further comprises a track member which has a groove defined therein which extends substantially parallel to the plane of the base-plate; and wherein the second projection member extends into the groove of the track member.

13. A testing assembly according to claim 11 or 12, comprising a first and second cam located at different stations, wherein the first cam is rotatable to move the first projection member from the level of the lower track to the level of the upper track to cause the second projection member to push upwards against the track member; wherein the second cam is rotatable to move the first projection member from the level of the upper track to the level of the lower track.

14. A testing assembly according to claim 13, wherein the first and second cams each comprise,
a rotatable plate-member which has a one or more cut-outs defined therein; each cut-out is dimensioned such that it can receive the first projection member of a follower of a nest;
wherein the plate-member is attached to a motor which is selectively operable to rotate the plate-member; and
a sensor which is configured to detect when a first projection member has been received into the cut-out of the plate-member of the cam and to initiate the motor to rotate the plate-member when the sensor has detected that a first projection member of a nest has been received into the cut-out of the plate-member.

## Patentansprüche

1. Ein Verfahren zum Testen eines Transistorbauteil(10), wobei das Verfahren die folgenden Schritte umfasst:
(a) Erfassen eines ersten Bildes des Transistorbauteil (10), das zum Testen in einem Nest (21) positioniert werden soll;
(b) Identifizieren der Positionen der Source und des Gates des Transistorbauteil (10) anhand des ersten Bildes;
(c) Halten des Transistorbauteil (10) unter Verwendung eines Bauteilhandhabungskopfes (5) auf einem drehbaren Drehkopf (3),
(d) Verwenden einer Ausrichtvorrichtung (15), um das Transistorbauteil (10) in eine Position auf dem Bauteilhandhabungskopf (5) zu bewegen, so dass der Bauteilhandhabungskopf (5) das Bauteil (10) in eine Position auf dem Nest (21) liefern kann, in der zwischen jedem von einer Vielzahl von elektrischen Kontakten (33) auf der Grundplatte (23a) des Nestes (21) und dem Drain des Transistorbauteils ein elektrischer Kontakt hergestellt wird, und in der zwischen einem Teil der Vielzahl von elektrischen Kontakten (43) auf der Abdeckplatte (23b) des Nestes (21) und dem Gate des Transistorbauteils (10) ein elektrischer Kontakt hergestellt wird und in der zwischen den verbleibenden elektrischen Kontakte (43) auf der Abdeckplatte (23b) des Nestes (21) und der Source des Transistorbauteils (10) ein elektrischer Kontakt hergestellt wird, wenn die Abdeckplatte (23b) zum Schließen des Nestes (21) bewegt wird;
(e) Zuführen des Transistorbauteils (10) zu dem Nest (21), so dass alle der Vielzahl der elektrischen Kontakte (33) auf der Grundplatte (23a) des Nestes (21) einen elektrischen Kontakt mit dem Drain des Transistorbauteil (10) herstellen;
(f) Bewegen der Abdeckplatte (23b) des Nestes, um die Grundplatte (23a) so zu überlagern, um das Nest (21) zu schließen, wobei ein Teil der Vielzahl von elektrischen Kontakten (43) auf der Abdeckplatte (23b) des Nestes (21) einen elektrischen Kontakt mit dem Gate des Transistorbauteils (10) herstellen wird, und wobei die restlichen elektrischen Kontakte (43) auf der Abdeckplatte (23b) des Nestes (21) einen elektrischen Kontakt mit der Source des Transistorbauteils (10) herstellen werden;
(g) Durchführen einer Prüfung des Transistorbauteils (10);
(h) Aufnehmen eines zweiten Bildes des Nestes (21), wenn das Nest (21) geschlossen ist, wobei das zweite Bild eine Seitenansicht der Deckplatte (23b), der Grundplatte (23a) und des Transistorbauteils (10) liefert; und
(i) Verwenden des zweiten Bildes, um zu bestimmen, ob alle der Vielzahl der elektrischen Kontakte (33) auf der Grundplatte (23a) des Nestes (21) den Drain des Transistorbauteils (10) überlagern, und um zu bestimmen, ob die verbleibenden elektrischen Kontakte (43) auf der Deckplatte (23b) des Nestes (21) die Source des Transistorbauteils (10) überlagern.

2. Verfahren nach Anspruch 1, das ferner den Schritt der Inspektion des zweiten Bildes umfasst, um festzustellen, ob zwischen den elektrischen Kontakten auf der Abdeckplatte des Nestes und dem Transistorbauteil eine Lücke vorhanden ist.

3. Verfahren nach Anspruch 2, das ferner den Schritt umfasst, die Position der Grundplatte in Richtung der Deckplatte zu bewegen, wenn anhand des zweiten Bildes festgestellt wird, dass zwischen den elektrischen Kontakten auf der Deckplatte des Nestes und dem Transistorbauteil eine Lücke besteht, bis das Transistorbauteil bewegt wird, um die Lücke zu schließen, sodass das Transistorbauteil die elektrischen Kontakte auf der Deckplatte elektrisch kontaktiert.

4. Verfahren nach Anspruch 1, das ferner den Schritt des Prüfens des zweiten Bildes umfasst, um festzustellen, ob der Abstand "R1" zwischen der Grundplatte und der Deckplatte auf einer Seite des Transistorbauteils sich von dem Abstand "R2" zwischen der Grundplatte und der Deckplatte auf einer zweiten, gegenüberliegenden Seite des Transistorbauteils unerscheidet.

5. Verfahren nach einem der Ansprüche 1 bis 4, wobei das zweite Bild aufgenommen wird, indem
Licht durch Fenster in der Abdeckplatte geleitet wird;
das Licht, das durch die Fenster hindurchgegangen ist, mit Hilfe von reflektierenden Elementen auf der Grundplatte auf das Bauteil, auf die Abdeckplatte und auf die Grundplatte reflektiert wird;
das Licht, das von dem Bauteil, der Abdeckplatte und der Grundplatte reflektiert wurde, über andere Fenster in der Abdeckplatte in die Kamera aufgenommen wird.

6. Verfahren nach einem der vorhergehenden Ansprüche, das ferner die folgenden Schritte umfasst:
Erfassen eines Bildes der Vielzahl elektrischen Kontakte, die auf der Grundplatte des Nestes vorhanden sind, und Bestimmen der Position der elektrischen Kontakte, die auf der Grundplatte des Nestes vorhanden sind, aus dem Bild; und
Erfassen eines Bildes der Vielzahl der elektrischen Kontakte, die auf der Deckplatte des Nestes vorhanden sind, und Bestimmen der Position der elektrischen Kontakte, die auf der Deckplatte des Nestes vorhanden sind, aus dem Bild; und
Erfassen eines Bildes der Transistorkomponente, die in das Nest geliefert werden soll, und Bestimmen zumindest der Positionen der Source und des Gates der Transistorkomponente aus dem Bild einer Transistorkomponente;
Bestimmen der Position auf dem Komponentenhandhabungskopf, in die die Ausrichtvorrichtung die Komponente in Schritt (d) bewegen sollte, aus dem Bild der Vielzahl von elektrischen Kontakten, die auf der Basisplatte des Nestes vorgesehen sind, dem Bild der Vielzahl von elektrischen Kontakten, die auf der Abdeckplatte des Nestes vorgesehen sind, und dem Bild der Transistorkomponente, die in das Nest geliefert werden soll.

7. Prüfanordnung, die zur Durchführung eines Verfahrens nach Anspruch 1 verwendet werden kann, wobei die Prüfanordnung einen Drehkopf (3) aufweist der folgendes umfasst:
eine Vielzahl von Bauteilhandhabungsköpfen (5), die jeweils ein Transistorbauteil (10) tragen können,
eine Ausrichtvorrichtung (15), die ein Transistorbauteil (10) in eine vordefinierte Position auf dem Bauteilhandhabungskopf (5) bewegen kann, umfasst;
einen Satellitentisch (22), der eine Vielzahl von Nestern (21) umfasst, wobei jedes Nest (21) eine Grundplatte (23a) und eine Abdeckplatte (23b) aufweist;
eine Kamera (81b), die so angeordnet ist, dass sie ein Bild der Grundplatte (23a) eines Nestes (21) aufnimmt, wobei das Bild verwendet werden kann, um die Position von elektrischen Kontakten (33) auf der Grundplatte (23a) zu bestimmen;
eine Kamera (81c), die so angeordnet ist, dass sie ein Bild der Abdeckplatte (23b) des Nestes (21) aufnimmt, wobei das Bild verwendet werden kann, um die Position von elektrischen Kontakten (43) auf der Abdeckplatte (23b) zu bestimmen;
eine Kamera (81e), die so angeordnet ist, dass sie ein Bild des Bauteils (10) aufnimmt, die in das Nest (21) geliefert werden soll;
eine Kamera (81a), die so angeordnet ist, dass sie ein Bild eines Nestes (21) aufnimmt, wenn das Nest (21) geschlossen ist, wobei das Bild eine Seitenansicht der Abdeckplatte (23b), der Grundplatte (23a) und des Transistorbauteils (10) liefert;
wobei die Ausrichtvorrichtung (15) so konfiguriert ist, dass sie die Bilder empfängt und auf der Grundlage der Bilder das Transistorbauteil (10) in eine Position auf dem Bauteilhandhabungskopf (5) bewegt, so dass der Bauteilhandhabungskopf (5) das Bauteil (10) in eine Position auf dem Nest (21) liefern kann, in der alle der Vielzahl der elektrischen Kontakte (33) auf der Grundplatte (23a) des Nestes (21) einen elektrischen Kontakt mit dem Drain des Transistorbauteils (10) herstellen werden, und ein Teil der Vielzahl von elektrischen Kontakten (43) auf der Abdeckplatte (23b) des Nestes (21) einen elektrischen Kontakt mit dem Gate des Transistorbauteils (10) herstellt und die verbleibenden elektrischen Kontakte (43) auf der Abdeckplatte (23b) des Nestes (21) einen elektrischen Kontakt mit der Source des Transistorbauteils (10) herstellen, wenn die Abdeckplatte (23b) zum Schließen des Nestes (21) bewegt.

8. Prüfanordnung nach Anspruch 7, bei der die Grundplatte eine erhöhte Plattform umfasst, die im Wesentlichen quadratisch ist und an jeder Seite des Quadrats vorspringende Abschnitte aufweist, und die Deckplatte eine erhöhte Plattform umfasst, die quadratisch ist und an jeder Seite des Quadrats vorspringende Abschnitte aufweist.

9. Prüfanordnung nach Anspruch 7 oder 8, wobei die Grundplatte eine Vielzahl von reflektierenden Elementen umfasst, die relativ zur Ebene der Grundplatte abgewinkelt sind; und die Abdeckplatte eine entsprechende Vielzahl von darin definierten Öffnungen umfasst, so dass, wenn die Abdeckplatte so angeordnet ist, dass sie die Grundplatte überlagert, jede Öffnung ein entsprechendes reflektierendes Element überlagert.

10. Prüfanordnung nach einem der Ansprüche 7 bis 9, bei der die Abdeckplatte schwenkbar an einem Nockebstössel angebracht ist, der mit einer Nocke zusammenwirken kann, wobei eine Bewegung des Nockenstössels in eine erste Richtung ein Schwenken der Abdeckplatte von der Grundplatte weg bewirkt und eine Bewegung des Nockenstössles in eine zweite Richtung ein Schwenken der Abdeckplatte zur Grundplatte hin bewirkt.

11. Prüfanordnung nach Anspruch 10, wobei der Nockenstössel ein Betätigungselement umfasst, das ein erstes und ein zweites Vorsprungselement umfasst, die in entgegengesetzte Richtungen vorstehen; wobei das erste Vorsprungselement auf einer oberen oder unteren Spur ruht und diese bewegen kann, wenn sich der Satellitentisch dreht, und mit einem Nocken zusammenwirken kann.

12. Prüfanordnung nach Anspruch 11, wobei der Nockenstössel ferner ein Schienenelement umfasst, in dem eine Nut vorgegeben ist, die sich im Wesentlichen parallel zur Ebene der Grundplatte erstreckt; und wobei sich das zweite Vorsprungselement in die Nut des Schienenelements erstreckt.

13. Prüfanordnung nach Anspruch 11 oder 12, die einen ersten und einen zweiten Nocken umfasst, die an unterschiedlichen Stationen angeordnet sind, wobei der erste Nocken drehbar ist, um das erste Vorsprungselement von der Ebene der unteren Schiene auf die Ebene der oberen Schiene zu bewegen, um zu bewirken, dass das zweite Vorsprungselement nach oben gegen das Schienenelement gedrückt wird; wobei der zweite Nocken drehbar ist, um das erste Vorsprungselement von der Ebene der oberen Schiene auf die Ebene der unteren Schiene zu bewegen.

14. Prüfanordnung nach Anspruch 13, wobei der erste und der zweite Nocken jeweils ein drehbares Plattenelement umfassen, das einen oder mehrere darin definierte Ausschnehmungen aufweist; wobei jede Ausnehmung so dimensioniert ist, dass sie das erste Vorsprungselement eines Nockenstössels eines Nests aufnehmen kann; wobei das Plattenelement an einem Motor befestigt ist, der selektiv betreibbar ist, um das Plattenelement zu drehen; und einen Sensor, der so konfiguriert ist, dass er erkennt, wenn ein erstes Vorsprungselement in der Ausnehmung des Plattenelements des Nockens aufgenommen worden ist, und dass er den Motor veranlasst, das Plattenelement zu drehen, wenn der Sensor erkannt hat, dass ein erstes Vorsprungselement eines Nests in die Ausnehmung des Plattenelements aufgenommen worden ist.

## Revendications

1. Procédé de test d'un composant de transistor (10), le procédé comprenant les étapes suivantes:
(a) capturer une première image du composant de transistor (10) qui est destiné à être mis dans un nid (21) pour le test ;
(b) identifier à partir de la première image les emplacements de la source et de la grille du composant de transistor (10) ;
(c) maintenir le composant de transistor (10) en utilisant une tête de manipulation de composant (5) sur une tourelle rotative (3),
(d) utiliser un dispositif d'alignement (15) pour déplacer le composant transistor (10) dans une position sur la tête de manipulation de composants (5) de telle sorte que la tête de manipulation de composants (5) puisse délivrer le composant (10) dans une position sur le nid (21) dans laquelle la totalité d'une pluralité de contacts électriques (33) sur la plaque de base (23a) du nid (21) établira un contact électrique avec le drain du composant transistor, et une partie de la pluralité de contacts électriques (43) sur la plaque de couverture (23b) du nid (21) établit un contact électrique avec la grille du composant transistor (10) et les contacts électriques restants (43) sur la plaque de couverture (23b) du nid (21) établissent un contact électrique avec la source du composant transistor (10), lorsque la plaque de couverture (23b) est déplacée pour fermer le nid (21);
(e) délivrer le composant de transistor (10) au nid (21) de sorte que la totalité de ladite pluralité de contacts électriques (33) sur la plaque de base (23a) du nid (21) établit un contact électrique avec le drain du composant de transistor (10) ;
(f) déplacer la plaque de couverture du nid (23b) pour recouvrir la plaque de base (23a) afin de fermer le nid (21) et une partie de la pluralité de contacts électriques (43) sur la plaque de couverture (23b) du nid (21) établit un contact électrique avec la grille du composant transistor (10) et les contacts électriques restants (43) sur la plaque de couverture (23b) du nid (21) établissent un contact électrique avec la source du composant transistor (10) ;
(g) effectuer des tests sur les composant transistor (10) ;
(h) capturer une seconde image du nid (21) lorsque le nid (21) est fermé, la seconde image fournissant une vue latérale de la plaque de couverture (23b), de la plaque de base (23a) et du composant de transistor (10) ; et
(i) utiliser la seconde image pour déterminer si la totalité de ladite pluralité de contacts électriques (33) sur la plaque de base (23a) du nid (21) recouvre le drain du composant transistor (10), et pour déterminer si lesdits contacts électriques restants (43) sur la plaque de couverture (23b) du nid (21) recouvrent la source du composant transistor (10).

2. Procédé selon la revendication 1 comprenant en outre l'étape d'inspecter la seconde image pour déterminer s'il existe un espace entre les contacts électriques sur la plaque de couverture du nid et le composant transistor.

3. Procédé selon la revendication 2 comprenant en outre l'étape de déplacer la position de la plaque de base vers la plaque de couverture s'il est déterminé à partir de la seconde image qu'il existe un espace entre les contacts électriques sur la plaque de couverture du nid et le composant de transistor, jusqu'à ce que le composant de transistor soit déplacé pour fermer l'espace de sorte que le composant de transistor contacte électriquement les contacts électriques sur la plaque de couverture.

4. Procédé selon la revendication 1 comprenant en outre l'étape consistant à inspecter la seconde image pour déterminer si la distance 'R1' entre la plaque de base et la plaque de couverture sur un côté du composant transistor diffère de la distance 'R2' entre la plaque de base et la plaque de couverture sur un second côté, opposé, du composant transistor.

5. Procédé selon l'une quelconque des revendications 1 à 4, dans lequel la seconde image est capturée
en faisant passer de la lumière à travers des fenêtres dans la plaque de couverture;
en réfléchissant la lumière qui est passée à travers les fenêtres vers le composant, la plaque de couverture et la plaque de base, en utilisant des éléments réfléchissants sur la plaque de base ;
en recevant dans la caméra, via d'autres fenêtres dans l'élément de couverture, la lumière qui a été réfléchie par le composant, la plaque de couverture et la plaque de base.

6. Procédé selon l'une quelconque des revendications précédentes comprenant en outre les étapes de
la capture d'une image de la pluralité de contacts électriques prévus sur la plaque de base du nid, et déterminer à partir de l'image la position des contacts électriques prévus sur la plaque de base du nid ; et
la capture d'une image de la pluralité de contacts électriques prévus sur la plaque de couverture du nid, et la détermination à partir de l'image de la position des contacts électriques prévus sur la plaque de couverture du nid ; et
la capture d'une image d'un composant de transistor qui est prévu d'être livré audit nid, et la détermination au moins des emplacements de la source et de la grille du composant de transistor à partir de ladite image du composant de transistor ;
la détermination à partir de ladite image de la pluralité de contacts électriques prévue sur la plaque de base du nid, de ladite image de la pluralité de contacts électriques prévue sur la plaque de couverture du nid, et de ladite image du composant transistor qui est prévu d'être livré audit nid, ladite position sur ladite tête de manipulation de composants dans laquelle le dispositif d'alignement doit déplacer le composant à l'étape (d)

7. Ensemble de test qui peut être utilisé pour réaliser un procédé selon la revendication 1, l'ensemble de test comprenant
une tourelle (3) ayant une pluralité de têtes de manipulation de composants (5) qui peuvent chacune porter un composant de transistor (10);
un dispositif d'alignement (15) qui peut déplacer un composant de transistor (10) dans une position prédéfinie sur la tête de manipulation de composants (5) ;
une table satellite (22) qui comprend une pluralité de nids (21), dans laquelle chaque nid (21) comprend une plaque de base (23a) et une plaque de couverture (23b);
une caméra (81b) qui est agencée pour capturer une image de la plaque de base (23a) du nid (21) dans lequel ladite image peut être utilisée pour déterminer la position des contacts électriques (33) sur la plaque de base (23a) ;
une caméra (81c) qui est agencée pour capturer une image de la plaque de couverture (23b) du nid, ladite image pouvant être utilisée pour déterminer la position des contacts électriques (43) sur la plaque de couverture (23b) ;
une caméra (81e) qui est agencée pour capturer une image du composant (10) qui doit être livré au nid (21) ;
une caméra (81a) qui est agencée pour capturer une image d'un nid (21) lorsque le nid (21) est fermé, l'image fournissant une vue latérale de la plaque de couverture (23b), de la plaque de base (23a) et du composant transistor (10) ;
dans lequel ledit dispositif d'alignement (15) est configuré pour recevoir lesdites images, et sur la base des images, déplacer le composant de transistor (10) dans une position sur la tête de manipulation de composant (5) de sorte que la tête de manipulation de composant (5) peut délivrer le composant (10) dans une position sur le nid (21) dans laquelle la totalité de ladite pluralité de contacts électriques (33) sur la plaque de base (23a) du nid (21) fera un contact électrique avec le drain du composant de transistor (10), et une partie de la pluralité de contacts électriques (43) sur la plaque de couverture (23b) du nid (21) établit un contact électrique avec la grille du composant transistor (10) et les contacts électriques restants (43) sur la plaque de couverture (23b) du nid (21) établissent un contact électrique avec la source du composant transistor (10), lorsque la plaque de couverture (23b) est déplacée pour fermer du nid (21).

8. Ensemble de test selon la revendication 7, dans lequel la plaque de base comprend une plate-forme surélevée qui est sensiblement carrée et avec des portions en saillie sur chaque côté respectif du carré ; et la plaque de couverture comprend une plate-forme surélevée qui est carrée et avec des portions en saillie sur chaque côté respectif du carré.

9. Ensemble de test selon la revendication 7 ou 8, dans lequel la plaque de base comprend une pluralité d'éléments réfléchissants qui sont inclinés par rapport au plan de la plaque de base ; et la plaque de couverture comprend une pluralité correspondante d'ouvertures définies dans celle-ci, de sorte que lorsque la plaque de couverture est disposée pour recouvrir la plaque de base, chaque ouverture recouvre un élément réfléchissant correspondant.

10. Ensemble de test selon l'une quelconque des revendications 7 à 9, dans lequel la plaque de couverture est montée de manière pivotante sur un suiveur qui peut coopérer avec une came ; dans lequel le déplacement du suiveur dans une première direction amène la plaque de couverture à pivoter en s'éloignant de la plaque de base, et le déplacement du suiveur dans une seconde direction amène la plaque de couverture à pivoter en se rapprochant de la plaque de base.

11. Ensemble de test selon la revendication 10, dans lequel le suiveur comprend un élément d'actionnement qui comprend un premier et un second élément de projection qui font saillie dans des directions opposées ; dans lequel le premier élément de projection repose sur et peut déplacer une piste supérieure ou inférieure lorsque la table du satellite tourne, et peut coopérer avec une came.

12. Ensemble de test selon la revendication 11, dans lequel le suiveur comprend en outre un élément de piste qui a une rainure définie dans celui-ci qui s'étend sensiblement parallèlement au plan de la plaque de base ; et dans lequel le second élément de projection s'étend dans la rainure de l'élément de piste.

13. Ensemble de test selon la revendication 11 ou 12, comprenant une première et une seconde came situées à des stations différentes, dans lequel la première came peut tourner pour déplacer le premier élément de projection du niveau de la piste inférieure au niveau de la piste supérieure pour amener le second élément de projection à pousser vers le haut contre l'élément de piste ; dans lequel la seconde came peut tourner pour déplacer le premier élément de projection du niveau de la piste supérieure au niveau de la piste inférieur.

14. Ensemble de test selon la revendication 13, dans lequel les première et seconde cames comprennent chacune un élément de plaque rotatif qui a une ou plusieurs découpes définies dans celui-ci ; chaque découpe est dimensionnée de telle sorte qu'elle peut recevoir le premier élément de projection d'un suiveur d'un nid ; dans lequel l'élément de plaque est fixé à un moteur qui peut être actionné sélectivement pour faire tourner l'élément de plaque ; et un capteur qui est configuré pour détecter quand un premier élément de projection a été reçu dans la découpe de l'élément de plaque de la came et pour initier le moteur pour faire tourner l'élément de plaque lorsque le capteur a détecté qu'un premier élément de projection d'un nid a été reçu dans la découpe de l'élément de plaque.
